# EUROPEAN PATENT APPLICATION

(11) **EP 4 804 771 A1**
(43) Date of publication of application: **09.09.2026**
(21) Application number: 25219279.4
(22) Date of filing: 28.11.2025
(51) Int. Cl.: H10H 29/14, H10H 29/24, H10H 29/80, H10H 29/85

(54) **LIGHT-EMITTING DEVICE AND DISPLAY APPARATUS INCLUDING THE SAME**

(30) Priority: 06.03.2025 KR 20250029199
(71) Applicant: Samsung Electronics Co., Ltd., Suwon-si, Gyeonggi-do 16677 (KR)
(72) Inventor: OH, Youngtek, 16677 Suwon-si (KR); KIM, Joosung, 16678 Suwon-si (KR); HWANG, Kyungwook, 16677 Suwon-si (KR); SHIN, Dongchul, 16677 Suwon-si (KR); HAN, Joohun, 16677 Suwon-si (KR); HWANG, Junsik, 16678 Suwon-si (KR)
(74) Representative: Arnold & Siedsma

(57) **Abstract**

Provided is a light-emitting device including an epitaxial structure that includes first, second, and third light-emitting structures having widths increasing in a vertical direction and each including a p-type semiconductor layer, an active layer, and an n-type semiconductor layer, first, second, and third p-electrodes, at least one of which has a conductive via structure, are on the epitaxial structure and respectively contact the p-type semiconductor layers of the first, second, and third light-emitting structures, an n-common electrode including an n-common portion on the epitaxial structure, and n-electrode portions extending from the n-common portion and respectively contacting side surfaces of the n-type semiconductor layers of the first, second, and third light-emitting structures, and a separation structure separating side surfaces of the p-type semiconductor layers and the active layers of the first, second, and third light-emitting structures from the n-common electrode.

## Description

### BACKGROUND

### 1. Field

The disclosure relates to a light-emitting device and a display apparatus including the same.

### 2. Description of Related Art

Light-emitting devices such as light-emitting diodes (LEDs) are known as next-generation light sources having advantages such as relatively long lifespan, low power consumption, fast response time, and environmental friendliness compared to light sources of the related art. Due to these advantages, the industrial demand for such light-emitting devices has increased. LEDs are commonly applied to various products such as lighting devices and display apparatuses.

Recently, ultra-small LEDs having microscale or nanoscale dimensions have been developed, and these are referred to as micro-LEDs. Micro-LEDs are applied to relatively large display apparatuses such as televisions, and further attempts have been made to apply micro-LEDs to small display apparatuses, such as displays for augmented reality (AR) devices. Micro-LEDs applied to small display apparatuses are extremely small, about several micrometers in size, making it difficult to secure a large emission area. In particular, in a micro-LED in which red, green, and blue (RGB) sub-pixels are vertically arranged, the emission area is reduced due to electrodes used to drive each sub-pixel, which may lead to a decrease in the luminous efficiency of the micro-LED.

### SUMMARY

Provided are a light-emitting device with improved luminous efficiency and a display apparatus including the light-emitting device.

Additional aspects will be set forth in part in the description which follows and, in part, will be apparent from the description, or may be learned by practice of embodiments.

According to an aspect of the disclosure, there is provided a light-emitting device including an epitaxial structure including a first light-emitting structure, a second light-emitting structure, and third light-emitting structure which are sequentially stacked in a vertical direction and configured to emit light of different wavelengths, a width of the first light-emitting structure being less than a width of the second light-emitting structure, and the width of the second light-emitting structure being less than a width of third light-emitting structure in a horizontal direction orthogonal to the vertical direction, each of the first light-emitting structure, the second light-emitting structure, and the third light-emitting structure including a p-type semiconductor layer, an active layer, and an n-type semiconductor layer, sequentially stacked, a first p-electrode contacting the p-type semiconductor layer of the first light-emitting structure, a second p-electrode contacting the p-type semiconductor layer of the second light-emitting structure, a third p-electrode contacting the p-type semiconductor layer of the third light-emitting structure, at least one of the first p-electrode, the second p-electrode, and the third p-electrode having a conductive via structure, an n-common electrode comprising an n-common portion under the epitaxial structure, and n-electrode portions extending from the n-common portion and contacting a side surface of the n-type semiconductor layer of each of the first light-emitting structure, the second light-emitting structure, and the third light-emitting structure, at least two of the n-electrode portions being on a side portion of the epitaxial structure and spaced apart from each other in the horizontal direction, and a separation structure layer between the n-common electrode and side surfaces of the p-type semiconductor layer and the active layer of each of the first light-emitting structure, the second light-emitting structure, and the third light-emitting structure.

In each of the first light-emitting structure, the second light-emitting structure, and the third light-emitting structure, the p-type semiconductor layer, the active layer, and the n-type semiconductor layer may be sequentially stacked.

A width of the active layer and a width of the p-type semiconductor layer of each of the first light-emitting structure, the second light-emitting structure, and the third light-emitting structure may be less than a width of the n-type semiconductor layer in the horizontal direction, and the n-electrode portions may include a first n-electrode portion, a second n-electrode portion, and a third n-electrode portion on the side portion of the epitaxial structure and spaced apart from each other in the horizontal direction, the first n-electrode portion contacts the side surface of the n-type semiconductor layer of the first light-emitting structure, the second n-electrode portion contacts the side surface of the n-type semiconductor layer of the second light-emitting structure, and the third n-electrode portion contacts the side surface of the n-type semiconductor layer of the third light-emitting structure.

The separation structure layer may include a first separation layer between the first n-electrode portion and the side surfaces of the p-type semiconductor layer and the active layer of the first light-emitting structure, a second separation layer between the second n-electrode portion and the side surfaces of the p-type semiconductor layer and the active layer of the second light-emitting structure, and a third separation layer between the third n-electrode portion and the side surfaces of the p-type semiconductor layer and the active layer of the third light-emitting structure.

The light-emitting device may further include a first protective layer between the first n-electrode portion and the second n-electrode portion, and a second protective layer between the second n-electrode portion and the third n-electrode portion.

The first p-electrode may contact the p-type semiconductor layer of the first light-emitting structure, the second p-electrode may pass through the first light-emitting structure and contact the p-type semiconductor layer of the second light-emitting structure, and the third p-electrode may pass through the first and second light-emitting structures and contact the p-type semiconductor layer of the third light-emitting structure.

The first light-emitting structure may be configured to emit red light, and one of the second light-emitting structure and the third light-emitting structure may be configured to emit blue light and the other one of the second light-emitting structure and the third light-emitting structure may be configured to emit green light.

In each of the first light-emitting structure, the second light-emitting structure, and the third light-emitting structure, the n-type semiconductor layer, the active layer, and the p-type semiconductor layer may be sequentially stacked.

In each of the second light-emitting structure and the third light-emitting structure, a width of the n-type semiconductor layer may be less than a width of the active layer and a width of the p-type semiconductor layer in the horizontal direction, the n-common electrode may contact the n-type semiconductor layer of the first light-emitting structure, and the n-electrode portions may include a second n-electrode portion and a third n-electrode portion on the side portion of the epitaxial structure spaced apart from each other in the horizontal direction, the second n-electrode portion may contact the side surface of the n-type semiconductor layer of the second light-emitting structure, and the third n-electrode portion may contact the side surface of the n-type semiconductor layer of the third light-emitting structure.

The separation structure layer may include a first separation layer between the second n-electrode portion and the side surfaces of the n-type semiconductor layer, the active layer, and the p-type semiconductor layer of the first light-emitting structure, and a second separation layer between the third n-electrode portion and the side surfaces of the p-type semiconductor layer and the active layer of the second light-emitting structure.

The first separation layer may partially extends from the p-type semiconductor layer of the first light-emitting structure to the n-type semiconductor layer of the second light-emitting structure, and the second separation layer may partially extends from the p-type semiconductor layer of the second light-emitting structure to the n-type semiconductor layer of the third light-emitting structure.

The light-emitting device may further include a protective layer between the second n-electrode portion and the third n-electrode portion.

The first p-electrode may pass through the n-type semiconductor layer and the active layer of the first light-emitting structure and contact the p-type semiconductor layer of the first light-emitting structure, the second p-electrode may pass through the first light-emitting structure and the n-type semiconductor layer and the active layer of the second light-emitting structure and contact the p-type semiconductor layer of the second light-emitting structure, and the third p-electrode may pass through the first and second light-emitting structures and the n-type semiconductor layer and the active layer of the second light-emitting structure and contact the p-type semiconductor layer of the third light-emitting structure.

One of the first light-emitting structure and the second light-emitting structure may be configured to generate blue light and the other one of the first light-emitting structure and the second light-emitting structure may be configured to generate green light, and the third light-emitting structure is configured to generate red light.

The light-emitting device may further include a lens on the epitaxial structure.

The n-common electrode may include a reflective electrode material.

The light-emitting device may further include an insulating layer between the first light-emitting structure and the second light-emitting structure and between the second light-emitting structure and the third light-emitting structure.

According to an aspect of the disclosure, there is provided a light-emitting device including an epitaxial structure including a first light-emitting structure, a second light-emitting structure, and third light-emitting structure sequentially stacked in a vertical direction and configured to emit light of different wavelengths, wherein each of the first light-emitting structure, the second light-emitting structure, and the third light-emitting structure includes a p-type semiconductor layer, an active layer, and an n-type semiconductor layer sequentially stacked, and a side surface of the n-type semiconductor layer of each of the first light-emitting structure, the second light-emitting structure, and the third light-emitting structure includes a concave portion having a stepped shape that is concave with respect to side surfaces of the active layer and the p-type semiconductor layer of each of the first light-emitting structure, the second light-emitting structure, and the third light-emitting structure, a first p-electrode contacting the p-type semiconductor layer of the first light-emitting structure, a second p-electrode contacting the p-type semiconductor layer of the second light-emitting structure, and a third p-electrode contacting the p-type semiconductor of the third light-emitting structure, at least one of the first p-electrode, the second p-electrode, and the third p-electrode having a conductive via structure, a separation structure layer on a side portion of the epitaxial structure and exposing the concave portion provided in the side surface of the n-type semiconductor layer of each of the first light-emitting structure, the second light-emitting structure, and the third light-emitting structure, and an n-common electrode including an n-common portion on the epitaxial structure, and an n-electrode portion extending along an outer surface of the separation structure layer from the n-common portion and contacting the side surface of the n-type semiconductor layer of each of the first light-emitting structure, the second light-emitting structure, and the third light-emitting structure through the concave portions.

The n-common electrode may include a reflective electrode material.

According to an aspect of the disclosure, there is provided a display apparatus including a display panel including a light-emitting device, a driving circuit configured to switch the light-emitting device on/off, and at least one processor configured to input an on-off switching signal from the light-emitting device to the driving circuit based on an image signal, wherein the light-emitting device includes an epitaxial structure comprising a first light-emitting structure, a second light-emitting structure, and third light-emitting structure which are sequentially stacked in a vertical direction and configured to emit light of different wavelengths, a width of the first light-emitting structure being less than a width of the second light-emitting structure, the width of the second light-emitting structure being less than a width of third light-emitting structure in a horizontal direction orthogonal to the vertical direction, each of the first light-emitting structure, the second light-emitting structure, and the third light-emitting structure comprising a p-type semiconductor layer, an active layer, and an n-type semiconductor layer which are sequentially stacked, a first p-electrode contacting the p-type semiconductor layer of the first light-emitting structure, a second p-electrode contacting the p-type semiconductor layer of the second light-emitting structure, a third p-electrode contacting the p-type semiconductor layer of the third light-emitting structure, at least one of the first p-electrode, the second p-electrode, and the third p-electrode having a conductive via structure, an n-common electrode comprising an n-common portion under the epitaxial structure, and n-electrode portions extending from the n-common portion and contacting the side surface of the n-type semiconductor layer of each of the first light-emitting structure, the second light-emitting structure, and the third light-emitting structure, at least two of the n-electrode portions being on a side portion of the epitaxial structure and spaced apart from each other in the horizontal direction, and a separation structure layer between the n-common electrode and side surfaces of the p-type semiconductor layer and the active layer of each of the first light-emitting structure, the second light-emitting structure, and the third light-emitting structure.

### BRIEF DESCRIPTION OF THE DRAWINGS

The above and other aspects, features, and advantages of certain embodiments will be more apparent from the following description taken in conjunction with the accompanying drawings, in which:
FIG. 1 is a cross-sectional view illustrating a light-emitting device, according to an embodiment;
FIG. 2 is a cross-sectional view illustrating a light-emitting device, according to an embodiment;
FIG. 3 is a cross-sectional view illustrating a light-emitting device, according to an embodiment;
FIG. 4 illustrates an example of a planar arrangement of an n-common electrode and p-electrodes;
FIG. 5 is a cross-sectional view illustrating a light-emitting device, according to an embodiment;
FIG. 6 is a cross-sectional view illustrating a light-emitting device, according to an embodiment;
FIGS. 7A, 7B, 7C, 7D, 7E, 7F, 7G, 7H, 7I, 7J, 7K, 7L, 7M, 7N, 7O, 7P, and 7Q illustrate an example of a method of manufacturing the light-emitting devices of FIGS. 1, 2, and 3;
FIGS. 8A, 8B, 8C, 8D, 8E, 8F, 8G, 8H, 8I, 8J, 8K, 8L, 8M, 8N, and 8O illustrate an example of a method of manufacturing the light-emitting device of FIG. 5;
FIG. 9 is a schematic view illustrating an embodiment of a display apparatus;
FIG. 10 is a block diagram illustrating an embodiment of an electronic device including a display;
FIG. 11 illustrates an embodiment of a mobile device as an application example of an electronic device;
FIG. 12 illustrates an embodiment of a head-up display apparatus for a vehicle as an application example of an electronic device;
FIG. 13 illustrates an embodiment of augmented reality glasses or virtual reality glasses as an application example of an electronic device;
FIG. 14 illustrates an embodiment of a large signage as an application example of an electronic device; and
FIG. 15 illustrates an embodiment of a wearable display as an application example of an electronic device.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, embodiments of a light-emitting device and a display apparatus including the same will be described in detail with reference to the accompanying drawings. Like reference numerals denote like elements throughout, and in the drawings, sizes of elements may be exaggerated for clarity and convenience of explanation. Also, the embodiments described below are merely examples, and various modifications may be made from the embodiments.

When an element is referred to as being "on" another element, it may be directly on the other element, or intervening elements may be present therebetween. The singular forms "a," "an," and "the" are intended to include the plural forms as well, unless the context clearly indicates otherwise. When a part "includes" an element, another element may be further included, rather than excluding the existence of the other element, unless otherwise described.

The use of the terms "a" and "an," and "the" and similar referents in the context of describing the present disclosure is to be construed to cover both the singular and the plural. The steps of all methods described herein may be performed in any suitable order unless otherwise indicated herein or otherwise clearly contradicted by context, and are not limited to the described order.

Also, lines or members connecting elements illustrated in the drawings are merely illustrative of functional connections and/or physical or circuit connections. In an actual device, the connections between elements may be represented by various functional connections, physical connections, or circuit connections that are replaceable or added.

The use of any and all examples, or language provided herein, is intended merely to describe the inventive concept in detail and does not pose a limitation on the scope of the inventive concept unless otherwise claimed.

Recently, technology for applying light-emitting devices, for example, micro-light-emitting diodes (LEDs), to displays has been greatly developed, and televisions to which micro-LEDs are applied have begun to be released. Furthermore, attempts have been made to apply micro-LEDs to augmented reality devices. In displays for augmented reality devices, very small micro-LED display chips (or panels) are monolithically made at a wafer level without a process of transferring micro-LEDs like in television displays. In television displays, the size of one pixel is tens to hundreds of micrometers, but in small or ultra-small displays such as displays for augmented reality devices, the size of one pixel is very small, for example, about several micrometers.

In order to display a color image on a display, one pixel (color pixel) includes RGB sub-pixels. An arrangement structure of RGB sub-pixels includes a horizontal arrangement structure and a vertical arrangement structure. In the horizontal arrangement structure, RGB sub-pixels are horizontally arranged, and in the vertical arrangement structure, RGB sub-pixels are vertically arranged. In the horizontal arrangement structure, each of sub-pixels may be referred to as a micro-LED. In the vertical arrangement structure, a micro-LED is a monolithic RGB micro-LED in which RGB sub-pixels are integrated.

For a color pixel of a given size, because the horizontal arrangement structure requires sub-pixels to be manufactured in a smaller size than the vertical arrangement structure, a horizontal process difficulty is high. In the vertical arrangement structure, because sub-pixels are vertically arranged, a vertical process difficulty is high. However, in the vertical arrangement structure, sub-pixels may be manufactured in a larger size than in the horizontal arrangement structure, which results in greater external quantum efficiency (EQE) than in the horizontal arrangement structure.

When RGB micro-LED chips having a vertical arrangement structure are manufactured, in order to form electrodes for driving sub-pixels, a conductive via that partially or entirely passes through the sub-pixels is required. For example, six electrodes are required to drive RGB sub-pixels, and five among the six electrodes are implemented by conductive vias. As the number of conductive vias increases, the emission area of a micro-LED decreases. In the case of small or ultra-small displays such as displays of augmented reality devices, because the size of a pixel is only a few micrometers, it may be difficult to secure a sufficient emission area when there are many conductive vias. Accordingly, it is necessary to reduce the number of conductive vias in order to secure a wide emission area.

The disclosure provides a light-emitting device, for example, a vertical RGB micro-LED, with improved luminous efficiency by reducing the number of conductive vias and securing a sufficient emission area, and a display apparatus using the light-emitting device. To this end, n-electrodes of a plurality of sub-pixels are formed in common. The size of each sub-pixel may be maximized by forming an n-common electrode on side surfaces of the sub-pixels. Also, because the number of conductive vias is reduced, the emission area may be secured, luminous efficiency may be increased, and power consumption may be reduced.

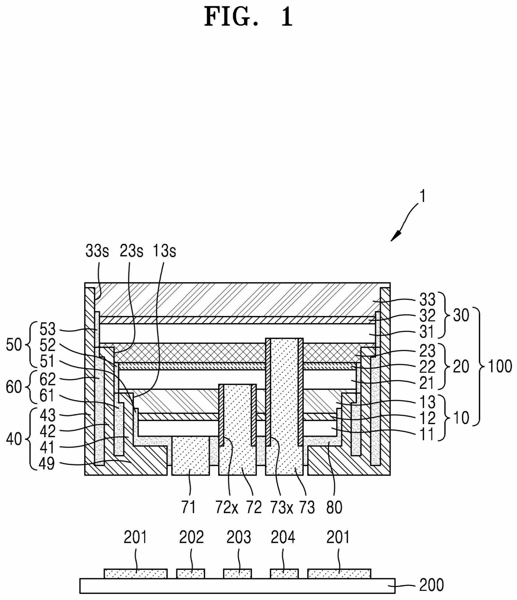

FIG. 1 is a schematic cross-sectional view illustrating a light-emitting device 1, according to an embodiment. The light-emitting device 1 of one or more embodiments is a vertically stacked light-emitting device in which a plurality of sub-pixels are vertically stacked. The light-emitting device 1 may be, for example, a micro-LED.

Referring to FIG. 1, the light-emitting device 1 includes an epitaxial structure 100 including a plurality of light-emitting structures that are vertically stacked, and a plurality of electrodes for driving the plurality of light-emitting structures. The light-emitting device 1 may correspond to one pixel in a display apparatus, and the plurality of light-emitting structures may correspond to sub-pixels that are vertically stacked to form one pixel. Each of the plurality of light-emitting structures may include a p-type semiconductor layer, an active layer having a quantum well structure, and an n-type semiconductor layer which are vertically epitaxially grown. The plurality of light-emitting structures may be vertically epitaxially grown and stacked to form the epitaxial structure 100. The plurality of electrodes include an n-common electrode common to the plurality of light-emitting structures and a plurality of p-electrodes respectively corresponding to the plurality of light-emitting structures. The plurality of p-electrodes are provided under the epitaxial structure 100 in the vertical direction and respectively contact the p-type semiconductor layers of the plurality of light-emitting structures. At least some of the plurality of p-electrodes have a conductive via structure passing through at least one of the plurality of light-emitting structures. The n-common electrode includes an n-common portion disposed under the epitaxial structure 100 and a plurality of n-electrode portions extending from the n-common portion. At least some of the plurality of n-electrode portions are arranged on a side portion of the epitaxial structure 100 to be spaced apart from each other in a horizontal direction orthogonal to a stacking direction, and respectively contact side surfaces of the n-type semiconductor layers of at least some of the plurality of light-emitting structures. The side portion refers to the part in the thickness direction of the epitaxial structure 100. The side surfaces refer to the surfaces in the thickness direction of a layer.

The epitaxial structure 100 may be formed of a group III-V nitride semiconductor material. Examples of the group III-V nitride semiconductor material may include gallium nitride (GaN), indium gallium nitride (InGaN), aluminum indium gallium nitride (AlInGaN), and aluminum gallium indium phosphide (AlGaInP). For example, the epitaxial structure 100 may be formed of a GaN-based semiconductor material. In one or more embodiments, the plurality of light-emitting structures may include a first light-emitting structure 10, a second light-emitting structure 20, and a third light-emitting structure 30 that are sequentially stacked. The first light-emitting structure 10 forms a lowermost layer of the epitaxial structure 100. The second light-emitting structure 20 is stacked on the first light-emitting structure 10, and the third light-emitting structure 30 is stacked on the second light-emitting structure 20 opposite to the first light-emitting structure 10. The third light-emitting structure 30 forms an uppermost layer of the epitaxial structure 100. In the active layer of each of the first, second, and third light-emitting structures 10, 20, and 30, bandgap energy may be controlled according to a composition ratio of indium (In) in a material layer including indium (In) to determine an emission wavelength band. The stacking direction of the first, second, and third light-emitting structures 10, 20, and 30 may be the same as a light-emitting direction. The epitaxial structure 100 according to an embodiment has a shape, for example, a stepped shape, whose width increases in the stacking direction. For example, a width of the first light-emitting structure 10 is the smallest, and a width of the third light-emitting structure 30 is the largest in the horizontal direction. According to this configuration, because light emitted from the first, second, and third light-emitting structures 10, 20, and 30 may be more effectively emitted in the light-emitting direction, light extraction efficiency may be improved.

Each of the first, second, and third light-emitting structures 10, 20, and 30 includes a p-type semiconductor layer, an active layer, and an n-type semiconductor layer which are stacked. For example, in one or more embodiments, each of the first, second, and third light-emitting structures 10, 20, and 30 has a structure in which a p-type semiconductor layer, an active layer, and an n-type semiconductor layer are sequentially stacked in the stacking direction. For example, in each of the first, second, and third light-emitting structures 10, 20, and 30, the p-type semiconductor layer is a lowermost layer, the active layer is stacked on the p-type semiconductor layer, and the n-type semiconductor layer is stacked on the active layer. Also, in each of the first, second, and third light-emitting structures 10, 20, and 30, the active layer and the p-type semiconductor layer have a stepped shape that is concave in the horizontal direction with respect to the n-type semiconductor layer. For example, a width of the active layer and a width of the p-type semiconductor layer are less than a width of the n-type semiconductor layer in the horizontal direction.

Referring to FIG. 1, the first light-emitting structure 10 may include a p-type semiconductor layer 11, an active layer 12 having a quantum well structure, and an n-type semiconductor layer 13 which are sequentially stacked in the stacking direction. The p-type semiconductor layer 11 may be a semiconductor layer doped with p-type impurities, for example, a p-GaN layer. Examples of the p-type impurities may include magnesium (Mg), zinc (Zn), and beryllium (Be). The active layer 12 is a layer that emits light due to recombination of electrons and holes. The active layer 12 may be formed by being grown on the p-type semiconductor layer 11. The active layer 12 has a quantum well structure. For example, the active layer 12 may have a single quantum well structure or a multi-quantum well structure made by periodically changing x, y, and z values in AlₓGa_{y}In_{z}N to adjust a bandgap. For example, a quantum well layer and a barrier layer may be paired in the form of InGaN/GaN, InGaN/InGaN, InGaN/AlGaN, or InGaN/InAlGaN to form a quantum well structure, and bandgap energy may be controlled according to a composition ratio of indium (In) of a material layer including indium (In) to adjust an emission wavelength band. The n-type semiconductor layer 13 may be formed on the active layer 12. The n-type semiconductor layer 13 may be a semiconductor layer doped with n-type impurities, for example, an n-GaN layer. Examples of the n-type impurities may include silicon (Si), germanium (Ge), selenium (Se), and tellurium (Te). The active layer 12 and the p-type semiconductor layer 11 have a stepped shape that is concave in the horizontal direction with respect to the n-type semiconductor layer 13. For example, a width of the active layer 12 and a width the p-type semiconductor layer 11 are less than a width of the n-type semiconductor layer 13 in the horizontal direction.

The second light-emitting structure 20 may include a p-type semiconductor layer 21, an active layer 22 having a quantum well structure, and an n-type semiconductor layer 23 which are sequentially stacked. The description of the p-type semiconductor layer 11, the active layer 12, and the n-type semiconductor layer 13 of the first light-emitting structure 10 may apply to the p-type semiconductor layer 21, the active layer 22, and the n-type semiconductor layer 23 of the second light-emitting structure 20. The third light-emitting structure 30 may include a p-type semiconductor layer 31, an active layer 32 having a quantum well structure, and an n-type semiconductor layer 33 which are sequentially stacked. The description of the p-type semiconductor layer 11, the active layer 12, and the n-type semiconductor layer 13 of the first light-emitting structure 10 may apply to the p-type semiconductor layer 31, the active layer 32, and the n-type semiconductor layer 33 of the third light-emitting structure 30. The first, second, and third light-emitting structures 10, 20, and 30 may be sequentially epitaxially grown and stacked to form the epitaxial structure 100.

For example, the first, second, and third light-emitting structures 10, 20, and 30 may emit light of different wavelengths. Color mixing may occur in micro-LEDs having a vertical arrangement structure. For example, when blue light is emitted, the blue light generated from a relatively high bandgap of a blue light-emitting structure may be absorbed by red/green light-emitting structures having lower bandgaps, resulting in absorption-induced-luminescence that emits red/green light, which may cause undesired color mixing. According to an embodiment, the first light-emitting structure 10, which is located at a lowermost position, in other words, forms a lowermost layer of the epitaxial structure 100, based on the light-emitting direction (stacking direction) of the light-emitting device 1, may emit red light, for example, light in a wavelength range of 630±20 nm. The second light-emitting structure 20 and the third light-emitting structure 30 may respectively emit green light (e.g., light in a wavelength range of 530±20 nm) and blue light (e.g., light in a wavelength range of 460±20 nm). Alternatively, the second light-emitting structure 20 and the third light-emitting structure 30 may respectively emit, for example, blue light and green light. Accordingly, because the first light-emitting structure 10 having a lowest bandgap is located at the bottom based on the light-emitting direction, the possibility that green light and blue light emitted from the second and third light-emitting structures 20 and 30 are absorbed by the first light-emitting structure 10 may be reduced. Accordingly, the light-emitting device 1 may have reduced color mixing due to absorption-induced-luminescence.

An n-common electrode 40 is an electrode common to the first, second, and third light-emitting structures 10, 20, and 30. The n-common electrode 40 may be electrically connected (in contact) to the n-type semiconductor layers 13, 23, and 33 of the first, second, and third light-emitting structures 10, 20, and 30. The n-common electrode 40 may include an n-common portion 49 disposed under the epitaxial structure 100, and n-electrode portions, for example, a first n-electrode portion 41, a second n-electrode portion 42, and a third n-electrode portion 43, extending from the n-common portion 49. For example, a passivation layer 80 may be provided on a bottom surface of the epitaxial structure 100, that is, a bottom surface of the first light-emitting structure 10, and the n-common portion 49 may be provided on a bottom surface of the passivation layer 80. The first, second, and third n-electrode portions 41, 42, and 43 extend from the n-common portion 49 and respectively contact side surfaces 13S, 23S, and 33S of the n-type semiconductor layers 13, 23, and 33 of the first, second, and third light-emitting structures 10, 20, and 30. The first, second, and third n-electrode portions 41, 42, and 43 may extend in the stacking direction along a side portion of the epitaxial structure 100. The first, second, and third n-electrode portions 41, 42, and 43 may be arranged on the side portion of the epitaxial structure 100 to be spaced apart from each other in the horizontal direction. For example, the first n-electrode portion 41 may be disposed at an innermost position, the second n-electrode portion 42 may be located outside the first n-electrode portion 41 (for example in reference to the middle of the light-emitting device 1), and the third n-electrode portion 43 may be disposed outside the second n-electrode portion 42 (for example in reference to the middle of the light-emitting device 1). The first, second, and third n-electrode portions 41, 42, and 43 may at least partially surround and/or be provided adjacent to the side portion of the epitaxial structure 100. For example, the first, second, and third n-electrode portions 41, 42, and 43 may entirely surround the side portion of the epitaxial structure 100, or may partially surround the side portion of the epitaxial structure 100. The n-common electrode 40 may include an electrode material. The electrode material may include, for example, aluminum (Al), titanium (Ti), platinum (Pt), silver (Ag), gold (Au), palladium (Pd), titanium tungsten (TiW), or any of various combinations thereof. The n-common electrode 40 may include a reflective electrode material, for example, Al or Ag. The n-common electrode 40 may include a transparent electrode material. The transparent electrode material may include, for example, ITO.

The light-emitting device 1 according to an embodiment may further include a passivation structure for insulation between the n-common electrode 40 and side surfaces of the p-type semiconductor layers 11, 21, and 31 and the active layers 12, 22, and 32 of the first, second, and third light-emitting structures 10, 20, and 30 and insulation between the first, second, and third n-electrode portions 41, 42, and 43. The passivation structure may include a separation structure layer 50 and a protective structure layer 60.

The separation structure layer 50 separates, for example, insulates, side surfaces of the p-type semiconductor layers 11, 21, and 31 and the active layers 12, 22, and 32 of the first, second, and third light-emitting structures 10, 20, and 30 from the n-common electrode 40 (for example, respectively from the first, second, and third n-electrode portions 41, 42, and 43 of the n-common electrode 40). The separation structure layer 50 may include a first separation layer 51, a second separation layer 52, and a third separation layer 53. The first separation layer 51 is disposed between the first n-electrode portion 41 and side surfaces of the p-type semiconductor layer 11 and the active layer 12 of the first light-emitting structure 10. The second separation layer 52 is disposed between the second n-electrode portion 42 and side surfaces of the p-type semiconductor layer 21 and the active layer 22 of the second light-emitting structure 20. The third separation layer 53 is disposed between the third n-electrode portion 43 and side surfaces of the p-type semiconductor layer 31 and the active layer 32 of the third light-emitting structure 30. A material of the separation structure layer 50 is not particularly limited. For example, the separation structure layer 50 may include a dielectric material. The dielectric material may include silicon oxide (SiO₂), titanium oxide (TiO₂), silicon nitride (Si₃N₄), aluminum oxide (AlOₓ), aluminum oxynitride (AlOₓN_{y}), tantalum oxide (Ta₂O₅), titanium nitride (TiN), aluminum nitride (AlN), zirconium oxide (ZrO₂), titanium alunimin indium nitride (TiAlN), titanium silicon nitride (TiSiN), hafnium oxide (HfOₓ), ZAZ, or any of various combinations thereof. A thickness of the separation structure layer 50 in the vertical direction is not particularly limited, and may be, for example, about 1 nm to about 300 nm. The separation structure layer 50 may restore side surfaces of the first, second, and third light-emitting structures 10, 20, and 30 damaged by an etching process described below. Also, materials suitable for the first, second, and third light-emitting structures 10, 20, and 30 may be selected as the first, second, and third separation layers 51, 52, and 53.

The protective layer 60 insulates the first, second, and third n-electrode portions 41, 42, and 43 from each other (preferably respectively on the side surfaces 13S, 23S, and 33S of the n-type semiconductor layers 13, 23, and 33 of the first, second, and third light-emitting structures 10, 20, and 30). The protective layer 60 may include a first protective layer 61 and a second protective layer 62. The first protective layer 61 is disposed between the first n-electrode portion 41 and the second n-electrode portion 42, and the second protective layer 62 is disposed between the second n-electrode portion 42 and the third n-electrode portion 43. The protective layer 60 protects the first and second n-electrode portions 41 and 42 in a process of sequentially forming the first, second, and third n-electrode portions 41, 42, and 43 described below. A material of the protective layer 60 is not particularly limited. For example, the protective layer 60 may include a dielectric material. The dielectric material may include SiO₂, TiO₂, Si₃N₄, AlOₓ, AlOₓN_{y}, Ta₂O₅, TiN, AlN, ZrO₂, TiAlN, TiSiN, HfOₓ, ZAZ, or any of various combinations thereof. The protective layer 60 may be formed of the same material as the separation structure layer 50. The protective layer 60 may be formed of a different material from the separation structure layer 50.

P-electrodes, for example, a first p-electrode 71, a second p-electrode 72, and a third p-electrode 73, may be disposed under the epitaxial structure 100. When the p-electrodes are provided under the epitaxial structure 100, the p-electrodes are provided under the epitaxial structure 100 in the stacking direction (vertical direction) of the plurality of light-emitting structures 10, 20, and 30. The first, second, and third p-electrodes 71, 72, and 73 respectively contact the p-type semiconductor layers 11, 21, and 31 of the first, second, and third light-emitting structures 10, 20, and 30. The first p-electrode 71 passes through the passivation layer 80 to contact a bottom surface of the p-type semiconductor layer 11 of the first light-emitting structure 10. The second and third p-electrodes 72 and 73 may have a conductive via structure. The second p-electrode 72 passes through the first light-emitting structure 10 from a bottom surface of the passivation layer 80 and electrically contacts the p-type semiconductor layer 21 of the second light-emitting structure 20. A passivation 72x insulates the second p-electrode 72 from the first light-emitting structure 10. The third p-electrode 73 passes through the first and second light-emitting structures 10 and 20 from a bottom surface of the passivation layer 80 and electrically contacts the p-type semiconductor layer 31 of the third light-emitting structure 30. A passivation 73x insulates the third p-electrode 73 from the first and second light-emitting structures 10 and 20. The passivations 72x and 73x may include a dielectric material. The dielectric material may include SiO₂, TiO₂, Si₃N₄, AlOₓ, AlOₓN_{y}, Ta₂O₅, TiN, AlN, ZrO₂, TiAlN, TiSiN, HfOₓ, ZAZ, or any of various combinations thereof. The p-electrodes may include an electrode material. The electrode material may include, for example, Al, Ti, Pt, Ag, Au, Pd, TiW, or any of various combinations thereof. The p-electrodes may include a transparent electrode material. The transparent electrode material may include, for example, ITO.

The light-emitting device 1 may be bonded to a substrate 200 of a display panel. The substrate 200 of the display panel may include bonding pads 201, 202, 203, and 204 respectively corresponding to the n-common portion 49 of the n-common electrode 40 and the first, second, and third p-electrodes 71, 72, and 73. In FIG. 1, the substrate 200 of the display panel is shown separated from the light-emitting device 1.

In the case of a vertical light-emitting device in which three light-emitting structures are stacked, in the state of the art three n-electrodes and three p-electrodes, that is, a total of six electrodes, are required to drive the light-emitting structures. When electrodes are individually formed for each light-emitting structure, five electrodes have a conductive via structure. In the vertical light-emitting device, when five electrodes have a conductive via structure, the emission area of each light-emitting device may be reduced by the area occupied by conductive vias, thereby lowering luminous efficiency. According to one or more embodiments, n-electrodes of a plurality of light-emitting structures are formed as one common electrode, and p-electrodes are formed as individual electrodes. The common electrode is formed on a side portion of the epitaxial structure 100 formed by stacking the light-emitting structures. Accordingly, the size of the light-emitting device 1, in other words, the size of the area occupied by pixels in a given pixel area may be maximized. Also, because the number of conductive via structures may be reduced to, for example, two as shown in FIG. 1, the emission area may be increased, and thus, luminous efficiency may be increased and power consumption may be reduced.

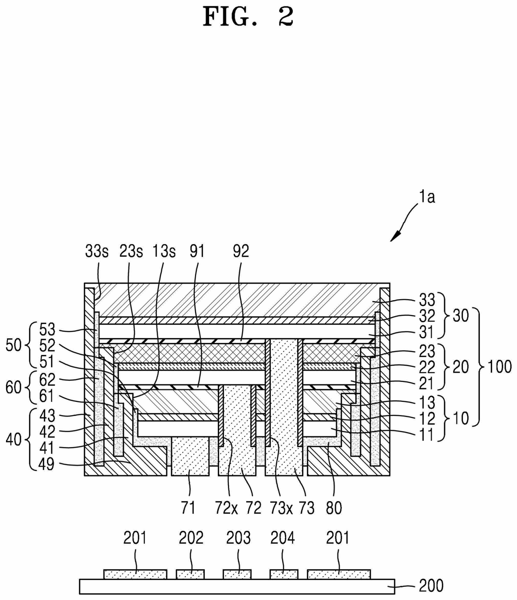

FIG. 2 is a schematic cross-sectional view illustrating a light-emitting device 1a, according to an embodiment. The light-emitting device 1a of one or more embodiments is a vertically stacked light-emitting device in which a plurality of sub-pixels are vertically stacked. The light-emitting device 1a may be, for example, a monolithic color micro-LED. The light-emitting device 1a of one or more embodiments is different from the light-emitting device 1 of FIG. 1 in that insulating layers 91 and 92 are provided. Hereinafter, the same elements are denoted by the same reference numerals, a repeated description will be omitted, and a difference will be mainly described.

Referring to FIG. 2, the insulating layer 91 may be disposed between the first and second light-emitting structures 10 and 20. The insulating layer 91 electrically insulates the n-type semiconductor layer 13 of the first light-emitting structure 10 from the p-type semiconductor layer 21 of the second light-emitting structure 20. The insulating layer 92 may be disposed between the second and third light-emitting structures 20 and 30. The insulating layer 92 insulates the n-type semiconductor layer 23 of the second light-emitting structure 20 from the p-type semiconductor layer 31 of the third light-emitting structure 30. The insulating layers 91 and 92 may be formed of, for example, a material that may be epitaxially grown together with the first, second, and third light-emitting structures 10, 20, and 30. For example, the insulating layers 91 and 92 may include AlGaN.

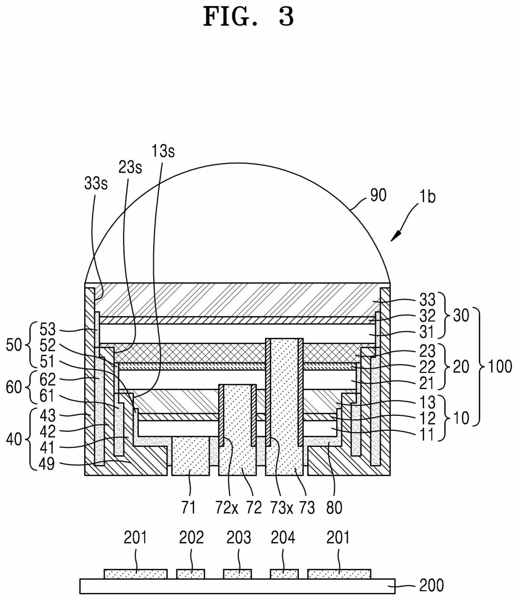

FIG. 3 is a schematic cross-sectional view illustrating a light-emitting device 1b, according to an embodiment. The light-emitting device 1b of one or more embodiments is different from the light-emitting device 1 of FIG. 1 in that a lens 90 is further provided. Hereinafter, a difference will be mainly described, the same elements having the same functions are denoted by the same reference numerals, and a repeated description will be omitted.

Referring to FIG. 3, the light-emitting device 1b may further include the lens 90. The lens 90 may be provided on the epitaxial structure 100, for example, on a light-emitting side of the epitaxial structure 100. For example, the lens 90 may be provided on the third light-emitting structure 30. The lens 90 may be formed by using, for example, thermoforming of a photoresist. The lens 90 may adjust an angle at which light generated from the first, second, and third light-emitting structures 10, 20, and 30 is emitted upward from the epitaxial structure 100. Accordingly, light may be emitted from the light-emitting device 1b in a desired angle range.

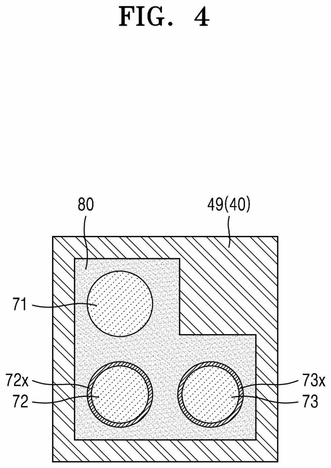

FIG. 4 illustrates an example of a planar arrangement of the n-common electrode 40 and the first, second, and third p-electrodes 71, 72, and 73. Referring to FIG. 4, the first, second, and third p-electrodes 71, 72, and 73 may be arranged inside the n-common portion 49 of the n-common electrode 40 (for example having a quadrangular shape) to be spaced apart from each other. A planar arrangement of the n-common electrode 40 and the first, second, and third p-electrodes 71, 72, and 73 is not limited to that shown FIG. 4.

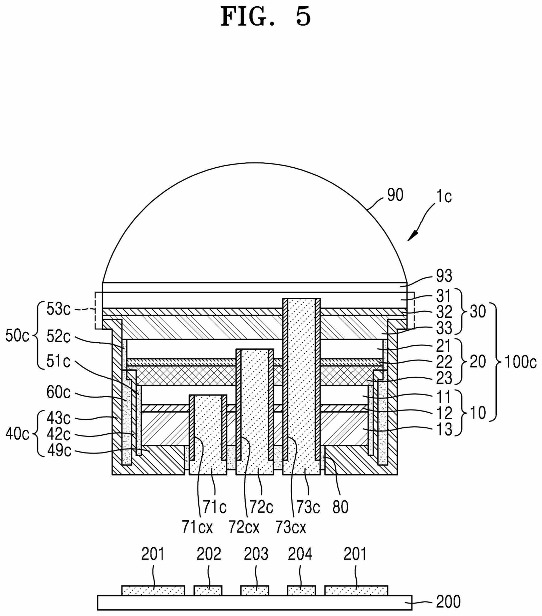

FIG. 5 is a schematic cross-sectional view illustrating a light-emitting device 1c, according to an embodiment. The light-emitting device 1c of one or more embodiments is different in that each of a plurality of light-emitting structures includes an n-type semiconductor layer, an active layer, and a p-type semiconductor layer which are sequentially stacked in the stacking direction and the third light-emitting structure 30 located on an uppermost layer of the epitaxial structure 100c emits red light, and in shapes of an n-common electrode and p-electrodes.

Referring to FIG. 5, the light-emitting device 1c includes an epitaxial structure 100c including a plurality of light-emitting structures that are vertically stacked, and a plurality of electrodes for driving the plurality of light-emitting structures. The light-emitting device 1c may correspond to one pixel in a display apparatus, and the plurality of light-emitting structures may correspond to sub-pixels that are vertically stacked to form one pixel. Each of the plurality of light-emitting structures includes an n-type semiconductor layer, an active layer having a quantum well structure, and a p-type semiconductor layer which are sequentially stacked in the stacking direction. The plurality of electrodes include an n-common electrode common to the plurality of light-emitting structures and a plurality of p-electrodes respectively corresponding to the plurality of light-emitting structures. The plurality of p-electrodes are provided under the epitaxial structure 100c and respectively contact the p-type semiconductor layers of the plurality of light-emitting structures. The plurality of p-electrodes have a conductive via structure passing through a light-emitting structure. The n-common electrode includes an n-common portion disposed under the epitaxial structure 100c, and a plurality of n-electrode portions. Some of the plurality of n-electrode portions are provided under the epitaxial structure 100c and contact bottom surfaces of the n-type semiconductor layers of some of the plurality of light-emitting structures, and thus, the n-common portion functions as some of the plurality of n-electrode portions. Others of the plurality of n-electrode portions are arranged on a side portion of the epitaxial structure 100c to be spaced apart from each other in the horizontal direction orthogonal to the stacking direction, and respectively contact side surfaces of the n-type semiconductor layers of the others of the plurality of light-emitting structures.

The epitaxial structure 100c may be formed of a group III-V nitride semiconductor material. Examples of the group III-V nitride semiconductor material may include GaN, InGaN, AlInGaN, and AlGaInP. For example, the epitaxial structure 100c may be formed of a GaN-based semiconductor material. In the active area, bandgap energy may be controlled according to a composition ratio of indium (In) of a material layer including indium (In) to determine an emission wavelength band. In one or more embodiments, the plurality of light-emitting structures may include the first, second, and third light-emitting structures 10, 20, and 30 that are sequentially stacked. The first light-emitting structure 10 forms a lowermost layer of the epitaxial structure 100c. The second light-emitting structure 20 is stacked on the first light-emitting structure 10, and the third light-emitting structure 30 is stacked on the second light-emitting structure 20 opposite to the first light-emitting structure 10 . The third light-emitting structure 30 forms an uppermost layer of the epitaxial structure 100c. The stacking direction of the first, second, and third light-emitting structures 10, 20, and 30 may be the same as the light-emitting direction. The epitaxial structure 100c according to an embodiment has a shape, for example, a stepped shape, whose width in the horizontal direction increases in the stacking direction. For example, a width of the first light-emitting structure 10 is the smallest, and a width of the third light-emitting structure 30 is the largest in the horizontal direction. According to this configuration, light emitted from the first, second, and third light-emitting structures 10, 20, and 30 may be more effectively emitted in the light-emitting direction.

Each of the first, second, and third light-emitting structures 10, 20, and 30 includes an n-type semiconductor layer, an active layer, and a p-type semiconductor layer which are sequentially stacked in the stacking direction. For example, in each of the first, second, and third light-emitting structures 10, 20, and 30, the n-type semiconductor layer is a lowermost layer, the active layer is stacked on the n-type semiconductor layer, and the p-type semiconductor layer is stacked on the active layer. Also, in each of the first, second, and third light-emitting structures 10, 20, and 30, the n-type semiconductor layer has a stepped shape that is concave in the horizontal direction with respect to the active layer and the p-type semiconductor layer. For example, a width of the n-type semiconductor layer is less than widths of the active layer and the p-type semiconductor layer in the horizontal direction.

Referring to FIG. 5, the first light-emitting structure 10 may include the n-type semiconductor layer 13, the active layer 12 having a quantum well structure, and the p-type semiconductor layer 11 which are sequentially stacked in the stacking direction. The n-type semiconductor layer 13 may be a semiconductor layer doped with n-type impurities, for example, an n-GaN layer. Examples of the n-type impurities may include Si, Ge, Se, and Te. The active layer 12 is a layer that emits light due to recombination of electrons and holes. The active layer 12 may be formed by being grown on the n-type semiconductor layer 13. The active layer 12 has a quantum well structure. For example, the active layer 12 may have a single quantum well structure or a multi-quantum well structure made by periodically changing x, y, and z values in AlₓGa_{y}In_{z}N to adjust a bandgap. For example, a quantum well layer and a barrier layer may be paired in the form of InGaN/GaN, InGaN/InGaN, InGaN/AlGaN, or InGaN/InAlGaN to form a quantum well structure, and bandgap energy may be controlled according to a composition ratio of indium (In) of a material layer including indium (In) to adjust an emission wavelength band. The p-type semiconductor layer 11 is grown on the active layer 12. The p-type semiconductor layer 11 may be a semiconductor layer doped with p-type impurities, for example, a p-GaN layer. Examples of the p-type impurities may include Mg, Zn, and Be. In the first light-emitting structure 10, a width of the n-type semiconductor layer 13, a width of the active layer 12, and a width of the p-type semiconductor layer 11 are the same in the horizontal direction.

The second light-emitting structure 20 may include the n-type semiconductor layer 23, the active layer 22 having a quantum well structure, and the p-type semiconductor layer 21 which are sequentially stacked. The description of the n-type semiconductor layer 13, the active layer 12, and the p-type semiconductor layer 11 of the first light-emitting structure 10 may apply to the n-type semiconductor layer 23, the active layer 22, and the p-type semiconductor layer 21 of the second light-emitting structure 20. However, in the second light-emitting structure 20, the n-type semiconductor layer 23 has a stepped shape that is concave in the horizontal direction with respect to the active layer 22 and the p-type semiconductor layer 21. For example, a width of the n-type semiconductor layer 23 is less than a width of the active layer 22 and a width of the p-type semiconductor layer 21 in the horizontal direction. The third light-emitting structure 30 may include the n-type semiconductor layer 33, the active layer 32 having a quantum well structure, and the p-type semiconductor layer 31 which are sequentially stacked. The description of the n-type semiconductor layer 13, the active layer 12, and the p-type semiconductor layer 11 of the first light-emitting structure 10 may apply to the n-type semiconductor layer 33, the active layer 32, and the p-type semiconductor layer 31 of the third light-emitting structure 30. However, in the third light-emitting structure 30, the n-type semiconductor layer 33 has a stepped shape that is concave in the horizontal direction with respect to the active layer 32 and the p-type semiconductor layer 31. For example, a width of the n-type semiconductor layer 33 is less than a width of the active layer 32 and a width of the p-type semiconductor layer 31 in the horizontal direction. The first, second, and third light-emitting structures 10, 20, and 30 are sequentially stacked to form the epitaxial structure 100c.

For example, the third light-emitting structure 30 located on a light-emitting side of the light-emitting device 1c, in other words, forming an uppermost layer of the epitaxial structure 100c, may emit red light, for example, light in a wavelength range of 630±20 nm. In general, the luminous efficiency of the third light-emitting structure 30 that emits red light is lower than that of light-emitting structure that emit light of other colors. The third light-emitting structure 30 that emits red light may be located on an uppermost layer of the epitaxial structure 100c so that only one via hole for forming a conductive via structure described below is formed in the active layer 32 of the third light-emitting structure 30. Accordingly, a decrease in the emission area of the third light-emitting structure 30 due to the conductive via structure may be reduced, thereby preventing a decrease in luminous efficiency. The first light-emitting structure 10 and the second light-emitting structure 20 may respectively emit blue light (e.g., light in a wavelength range of 460±20 nm) and green light (e.g., light in a wavelength range of 530±20 nm). The first light-emitting structure 10 and the second light-emitting structure 20 may respectively emit, for example, green light and blue light.

An n-common electrode 40c is an electrode common to the first, second, and third light-emitting structures 10, 20, and 30. The n-common electrode 40c may be electrically connected to the n-type semiconductor layers 13, 23, and 33 of the first, second, and third light-emitting structures 10, 20, and 30. The n-common electrode 40c may include an n-common portion 49c, and n-electrode portions extending from the n-common portion 49c. The n-common portion 49c is disposed under the epitaxial structure 100c in the vertical direction. In one or more embodiments, the n-common portion 49c functions as the first n-electrode portion 41 in the embodiment of FIG. 1. To this end, the n-common portion 49c contacts a bottom surface of the n-type semiconductor layer 13 of the first light-emitting structure 10. The n-electrode portions may include a second n-electrode portion 42c and a third n-electrode portion 43c. The second and third n-electrode portions 42c and 43c extend from the n-common portion 49 and respectively contact the side surfaces 23S and 33S of the n-type semiconductor layers 23 and 33 of the second and third light-emitting structures 20 and 30. The second and third n-electrode portions 42c and 43c may extend in the stacking direction along a side portion of the epitaxial structure 100c and may be spaced apart from each other in the horizontal direction. For example, the second n-electrode portion 42c may be located at an innermost position, and the third n-electrode portion 43c may be disposed outside the second n-electrode portion 42c. The second and third n-electrode portions 42c and 43c may at least partially surround and/or be provided adjacent to the side portion of the epitaxial structure 100c. For example, the second and third n-electrode portions 42c and 43c may entirely surround the side portion of the epitaxial structure 100c, or may partially surround the side portion of the epitaxial structure 100c. The n-common electrode 40c may include an electrode material. The electrode material may include, for example, Al, Ti, Pt, Ag, Au, Pd, TiW, or any of various combinations thereof. The n-common electrode 40c may include a reflective electrode material, for example, Al or Ag. The n-common electrode 40c may include a transparent electrode material. The transparent electrode material may include, for example, indium tin oxide (ITO).

The light-emitting device 1c according to an embodiment may further include a passivation structure for insulation between the n-common electrode 40c and side surfaces of the p-type semiconductor layer 11, the active layer 12, and the n-type semiconductor layer 13 of the first light-emitting structure 10 and the p-type semiconductor layer 21 and the active layer 22 of the second light-emitting structure 20 and insulation between the second and third n-electrode portions 42c and 43c. The passivation structure may include a separation structure layer 50c and a protective layer 60c.

The separation structure layer 50c separates, for example, insulates, side surfaces of the p-type semiconductor layer 11, the active layer 12, and the n-type semiconductor layer 13 of the first light-emitting structure 10 and the p-type semiconductor layer 21 and the active layer 22 of the second light-emitting structure 20 from the n-common electrode 40c (for example, from the second and third n-electrode portions 42c and 43c of the n-common electrode 40c). The separation structure layer 50c may include a first separation layer 51c and a second separation layer 52c. The first separation layer 51c is disposed between the second n-electrode portions 42c and side surfaces of the p-type semiconductor layer 11, the active layer 12, and the n-type semiconductor layer 13 of the first light-emitting structure 10. The first separation layer 51c may partially extend beyond and/or protrude from the p-type semiconductor layer 11 of the first light-emitting structure 10 to the n-type semiconductor layer 23 of the second light-emitting structure 20. The second separation layer 52c is disposed between the third n-electrode portion 43c and side surfaces of the p-type semiconductor layer 21 and the active layer 22 of the second light-emitting structure 20. The second separation layer 52c may partially extend beyond and/or protrude from the p-type semiconductor layer 21 of the second light-emitting structure 20 to the n-type semiconductor layer 33 of the third light-emitting structure 30. The separation structure layer 50c may further include a third separation layer 53c that is provided on and/or covers side surfaces of the active layer 32 and the p-type semiconductor layer 31 of the third light-emitting structure 30. A material of the separation structure layer 50c is not particularly limited. For example, the separation structure layer 50c may include a dielectric material. The dielectric material may include SiO₂, TiO₂, Si₃N₄, AlOₓ, AlOₓN_{y}, Ta₂O₅, TiN, AlN, ZrO₂, TiAlN, TiSiN, HfOₓ, ZAZ, or any of various combinations thereof. A thickness of the separation structure layer 50c in the vertical direction is not particularly limited, and may be, for example, about 1 nm to about 300 nm. The separation structure layer 50c may restore side surfaces of the first and second light-emitting structures 10 and 20 damaged by an etching process described below. Also, materials suitable for the first, second, and third light-emitting structures 10, 20, and 30 may be selected as the first, second, and third separation layers 51c, 52c, and 53c.

The protective layer 60c insulates the second and third n-electrode portions 42c and 43c from each other. The protective layer 60c is disposed between the second n-electrode portion 42c and the third n-electrode portion 43c. The protective layer 60c protects the second n-electrode portion 42c in a process of sequentially forming the second and third n-electrode portions 42c and 43c described below. A material of the protective layer 60c is not particularly limited. For example, the protective layer 60c may include a dielectric material. The dielectric material may include SiO₂, TiO₂, Si₃N₄, AlOₓ, AlOₓN_{y}, Ta₂O₅, TiN, AlN, ZrO₂, TiAlN, TiSiN, HfOₓ, ZAZ, or any of various combinations thereof. The separation structure layer 50c and the protective layer 60c may be formed of the same material or different materials.

P-electrodes, for example, a first p-electrode 71c, a second p-electrode 72c, and a third p-electrode 73c are disposed under the epitaxial structure 100c and respectively contact the p-type semiconductor layers 11, 21, and 31 of the first, second, and third light-emitting structures 10, 20, and 30. The first, second, and third p-electrodes 71c, 72c, and 73c may have a conductive via structure. The first p-electrode 71c passes through the passivation layer 80 and the n-type semiconductor layer 13 and the active layer 12 of the first light-emitting structure 10 to contact the p-type semiconductor layer 11. A passivation 71cx insulates the first p-electrode 71c from the n-type semiconductor layer 13 and the active layer 12 of the first light-emitting structure 10. The second p-electrode 72c passes through the passivation layer 80, the first light-emitting structure 10, and the n-type semiconductor layer 23 and the active layer 22 of the second light-emitting structure 20 to electrically contact the p-type semiconductor layer 21. A passivation 72cx insulates the second p-electrode 72c from the first light-emitting structure 10 and the n-type semiconductor layer 23 and the active layer 22 of the second light-emitting structure 20. The third p-electrode 73c passes through the passivation layer 80, the first and second light-emitting structures 10 and 20, and the n-type semiconductor layer 33 and the active layer 32 of the third light-emitting structure 30 to electrically contact the p-type semiconductor layer 31. A passivation 73cx insulates the third p-electrode 73c from the first and second light-emitting structures 10 and 20 and the n-type semiconductor layer 33 and the active layer 32 of the third light-emitting structure 30. The passivations 71cx, 72cx, and 73cx may include a dielectric material. The dielectric material may include SiO₂, TiO₂, Si₃N₄, AlOₓ, AlOₓN_{y}, Ta₂O₅, TiN, AlN, ZrO₂, TiAlN, TiSiN, HfOₓ, ZAZ, or any of various combinations thereof. The p-electrodes may include an electrode material. The electrode material may include, for example, Al, Ti, Pt, Ag, Au, Pd, TiW, or any of various combinations thereof. The p-electrodes may include a transparent electrode material. The transparent electrode material may include, for example, ITO.

The light-emitting device 1c may be bonded to the substrate 200 of the display panel. The substrate 200 of the display panel may include the bonding pads 201, 202, 203, and 204 respectively corresponding to the n-common portion 49c of the n-common electrode 40c and the first, second, and third p-electrodes 71c, 72c, and 73c. In FIG. 5, the substrate 200 of the display panel is shown separated from the light-emitting device 1c.

The insulating layer 91 (see FIG. 2) may be disposed between the first and second light-emitting structures 10 and 20 to electrically insulate the p-type semiconductor layer 11 of the first light-emitting structure 10 from the n-type semiconductor layer 23 of the second light-emitting structure 20, and the insulating layer 92 (see FIG. 2) may be disposed between the second and third light-emitting structures 20 and 30 to electrically insulate the p-type semiconductor layer 21 of the second light-emitting structure 20 from the n-type semiconductor layer 33 of the third light-emitting structure 30.

Referring to FIG. 5, the light-emitting device 1c may further include the lens 90. The lens 90 may be provided on the epitaxial structure 100c, for example, on a light-emitting side of the epitaxial structure 100c. A passivation layer 93 may be provided on the epitaxial structure 100c, and the lens 90 may be provided on the passivation layer 93. The lens 90 may be formed by using, for example, thermoforming of a photoresist. The lens 90 may adjust an angle at which light generated from the first, second, and third light-emitting structures 10, 20, and 30 is emitted upward from the epitaxial structure 100c. Accordingly, light may be emitted from the light-emitting device 1c in a desired angle range.

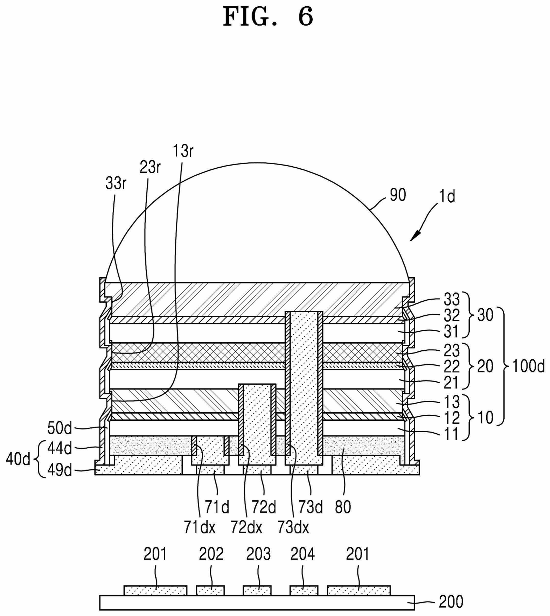

FIG. 6 is a schematic cross-sectional view illustrating a light-emitting device 1d, according to an embodiment. Referring to FIG. 6, the light-emitting device 1d according to an embodiment may include an epitaxial structure 100d, an n-common electrode 40d, a separation structure layer 50d, and p-electrodes (e.g., 71d, 72d, and 73d).

The epitaxial structure 100d includes the first, second, and third light-emitting structures 10, 20, and 30 that are sequentially stacked and emit light of different wavelengths. Each of the first, second, and third light-emitting structures 10, 20, and 30 includes a p-type semiconductor layer, an active layer, and an n-type semiconductor layer which are sequentially stacked. The description of the epitaxial structure 100 of FIG. 1 may apply to the epitaxial structure 100d of one or more embodiments. However, the epitaxial structure 100d of one or more embodiments is different from the epitaxial structure 100 of FIG. 1 in that a side surface thereof is substantially parallel to the stacking direction. Accordingly, members having the same functions are denoted by the same reference numerals and a repeated description will be omitted. For example, the third light-emitting structure 30 located on a light-emitting side of the light-emitting device 1d, in other words, forming an uppermost layer of the epitaxial structure 100d, may emit blue light (e.g., light in a wavelength range of 460±20 nm). The first light-emitting structure 10 and the second light-emitting structure 20 may respectively emit red light (e.g., light in a wavelength range of 630±20 nm) and green light (e.g., light in a wavelength range of 530±20 nm).

A side surface of the n-type semiconductor layer of each of the first, second, and third light-emitting structures 10, 20, and 30 includes a concave portion having a stepped shape that is concave with respect to side surfaces of the active layer and the p-type semiconductor layer of each of the first, second, and third light-emitting structures 10, 20, and 30. For example, a side surface of the n-type semiconductor layer 13 of the first light-emitting structure 10 includes a concave portion 13r that is concave with respect to side surfaces of the active layer 12 and the p-type semiconductor layer 11. A side surface of the n-type semiconductor layer 23 of the second light-emitting structure 20 includes a concave portion 23r that is concave with respect to side surfaces of the active layer 22 and the p-type semiconductor layer 21. A side surface of the n-type semiconductor layer 33 of the third light-emitting structure 30 includes a concave portion 33r that is concave with respect to side surfaces of the active layer 32 and the p-type semiconductor layer 31.

The separation structure layer 50d is provided on and/or covers a side portion of the epitaxial structure 100d. A plurality of openings corresponding to the concave portions 13r, 23r, and 33r provided in the side surfaces of the n-type semiconductor layers 13, 23, and 33 of the first, second, and third light-emitting structures 10, 20, and 30 are provided in the separation structure layer 50d, and the concave portions 13r, 23r, and 33r are exposed to the side portion of the epitaxial structure 100d through the plurality of openings. The separation structure layer 50d may be provided entirely or partially on and/or cover the side portion of the epitaxial structure 100d. A material of the separation structure layer 50d is not particularly limited. For example, the separation structure layer 50d may include a dielectric material. The dielectric material may include SiO₂, TiO₂, Si₃N₄, AlOₓ, AlOₓN_{y}, Ta₂O₅, TiN, AlN, ZrO₂, TiAlN, TiSiN, HfOₓ, ZAZ, or any of various combinations thereof. A thickness of the separation structure layer 50d in the vertical direction is not particularly limited.

The n-common electrode 40d contacts the side surfaces of the n-type semiconductor layers 13, 23, and 33 of the first, second, and third light-emitting structures 10, 20, and 30 through the concave portions 13r, 23r, and 33r. In an embodiment, the n-common electrode 40d may include an n-common portion 49d and an n-electrode portion 44d electrically connected to the n-common portion 49d. The n-common portion 49d may be disposed under the epitaxial structure 100d. In an embodiment, the passivation layer 80 may be disposed under the epitaxial structure 100d, and the n-common portion 49d may be provided on a bottom surface of the passivation layer 80. The n-electrode portion 44d extends along an outer surface of the separation structure layer 50d from the n-common portion 49d. The n-electrode portion 44d may partially or entirely cover the outer surface of the separation structure layer 50d. The n-electrode portion 44d contacts the side surfaces of the n-type semiconductor layers 13, 23, and 33 of the first, second, and third light-emitting structures 10, 20, and 30 through the concave portions 13r, 23r, and 33r. The n-common electrode 40d may include an electrode material. The electrode material may include, for example, Al, Ti, Pt, Ag, Au, Pd, TiW, or any of various combinations thereof. The n-common electrode 40d may include a reflective electrode material, for example, Al or Ag. The n-common electrode 40d may include a transparent electrode material. The transparent electrode material may include, for example, ITO.

The p-electrodes, for example, a first p-electrode 71d, a second p-electrode 72d, and a third p-electrode 73d, are disposed under the epitaxial structure 100d and respectively contact the p-type semiconductor layers 11, 21, and 31 of the first, second, and third light-emitting structures 10, 20, and 30. The first, second, and third p-electrodes 71d, 72d, and 73d may have a conductive via structure. The first p-electrode 71d passes through the passivation layer 80 and contacts the p-type semiconductor layer 11 of the first light-emitting structure 10. Optionally, a passivation 71dx provided adjacent to and/or surrounding an outer circumference of the first p-electrode 71d may be provided. The passivation 71dx insulates the first p-electrode 71d from the passivation layer 80. The second p-electrode 72d passes through the passivation layer 80 and the first light-emitting structure 10 and electrically contacts the p-type semiconductor layer 21 of the second light-emitting structure 20. A passivation 72dx insulates the second p-electrode 72d from the first light-emitting structure 10. The third p-electrode 73d passes through the passivation layer 80 and the first and second light-emitting structures 10 and 20 and electrically contacts the p-type semiconductor layer 31 of the third light-emitting structure 30. A passivation 73dx insulates the third p-electrode 73d from the first and second light-emitting structures 10 and 20. The passivations 71dx, 72dx, and 73dx may include a dielectric material. The dielectric material may include SiO₂, TiO₂, Si₃N₄, AlOₓ, AlOₓN_{y}, Ta₂O₅, TiN, AlN, ZrO₂, TiAlN, TiSiN, HfOₓ, ZAZ, or any of various combinations thereof. The p-electrodes may include an electrode material. The electrode material may include, for example, Al, Ti, Pt, Ag, Au, Pd, TiW, or any of various combinations thereof. The p-electrodes may include a transparent electrode material. The transparent electrode material may include, for example, ITO.

The light-emitting device 1d may be bonded to the substrate 200 of the display panel. The substrate 200 of the display panel may include the bonding pads 201, 202, 203, and 204 respectively corresponding to the n-common portion 49d of the n-common electrode 40d and the first, second, and third p-electrodes 71d, 72d, and 73d. In FIG. 6, the substrate 200 of the display panel is shown separated from the light-emitting device 1d.

The insulating layer 91 (see FIG. 2) may be disposed between the first and second light-emitting structures 10 and 20 to electrically insulate the p-type semiconductor layer 11 of the first light-emitting structure 10 from the n-type semiconductor layer 23 of the second light-emitting structure 20, and the insulating layer 92 (see FIG. 2) may be disposed between the second and third light-emitting structures 20 and 30 to electrically insulate the p-type semiconductor layer 21 of the second light-emitting structure 20 from the n-type semiconductor layer 33 of the third light-emitting structure 30.

Referring to FIG. 6, the light-emitting device 1d may further include the lens 90. The lens 90 may be provided on the epitaxial structure 100d, for example, on a light-emitting side of the epitaxial structure. The lens 90 may be formed by using, for example, thermoforming of a photoresist. The lens 90 may adjust an angle at which light generated from the first, second, and third light-emitting structures 10, 20, and 30 is emitted upward from the epitaxial structure 100d. Accordingly, light may be emitted from the light-emitting device 1d in a desired angle range.

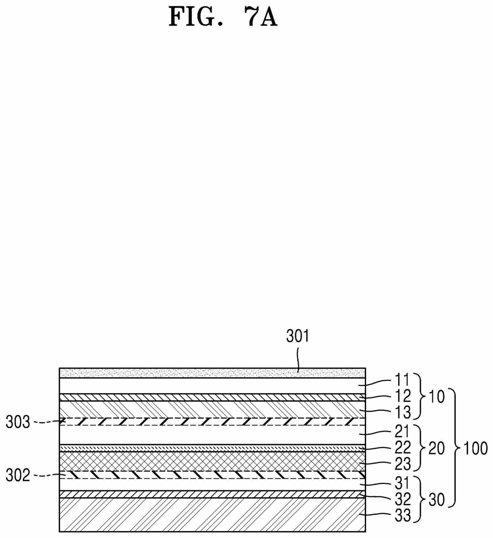

Hereinafter, a method of manufacturing embodiments of the light-emitting devices of FIGS. 1 to 3 will be described. FIGS. 7A to 7Q illustrate an example of a method of manufacturing the light-emitting devices 1, 1a, and 1b of FIGS. 1 to 3.

First, a process of forming the epitaxial structure 100 is performed. Referring to FIG. 7A, the third light-emitting structure 30, the second light-emitting structure 20, and the first light-emitting structure 10 are sequentially stacked and grown on a growth substrate. The growth substrate is a growth substrate for semiconductor single crystal growth, and for example, a silicon (Si) substrate, a silicon carbide (SiC) substrate, or a sapphire substrate may be used. In addition, a substrate formed of a material suitable for the growth of a light-emitting structure to be formed on the growth substrate, for example, AlN, AlGaN, zinc oxide (ZnO), gallium arsenide (GaAs), magnesium aluminum oxide (MgAl₂O₄), magnesium oxide (MgO), lithium aluminum oxide (LiAlO₂), lithium gallium oxide (LiGaO₂), or GaN, may be used. When necessary, a buffer layer necessary for epitaxial growth of a light-emitting structure may be provided on a surface of the growth substrate, and the light-emitting structure may be grown on the buffer layer.

For example, the n-type semiconductor layer 33, the active layer 32, and the p-type semiconductor layer 31 may be sequentially grown on the growth substrate to form the third light-emitting structure 30. The third light-emitting structure 30 may be formed of a group III-V nitride semiconductor material. Examples of the group III-V nitride semiconductor material may include GaN, InGaN, AlInGaN, and AlGaInP. In one or more embodiments, the third light-emitting structure 30 is formed of a GaN-based semiconductor material. The n-type semiconductor layer 33 may be an n-GaN layer doped with n-type impurities such as Si, Ge, Se, or Te. The active layer 32 is a layer that emits light due to recombination of electrons and holes, and may have a single quantum well structure or a multi-quantum well structure as described above. For example, a quantum well layer and a barrier layer may be paired in the form of InGaN/GaN, InGaN/InGaN, InGaN/AlGaN, or InGaN/InAlGaN to form a quantum well structure, and bandgap energy may be controlled according to a composition ratio of indium (In) of a material layer including indium (In) to adjust an emission wavelength band. The p-type semiconductor layer 31 is a p-GaN layer doped with p-type impurities such as Mg, Zn, or Be. The description of the third light-emitting structure 30 may apply to the second light-emitting structure 20 and the first light-emitting structure 10. The first, second, and third light-emitting structures 10, 20, and 30 may be formed by using, for example, hydride vapor phase epitaxy (HVPE), molecular beam epitaxy (MBE), metal organic vapor phase epitaxy (MOVPE), metal organic chemical vapor deposition (MOCVD), or the like, or a combination thereof. Accordingly, the epitaxial structure 100 is formed. Next, a passivation layer 301 is formed by depositing a dielectric material on the first light-emitting structure 10. The dielectric material may include, for example, SiO₂, TiO₂, Si₃N₄, AlOₓ, AlOₓN_{y}, Ta₂O₅, TiN, AlN, ZrO₂, TiAlN, TiSiN, HfOₓ, or any of various combinations thereof. In one or more embodiments, the passivation layer 301 is formed of SiO₂, which is a light-transmitting dielectric material. For example, the passivation layer 301 may be formed by using, for example, sputtering, atomic layer deposition (ALD), plasma enhanced atomic layer deposition (PEALD), chemical vapor deposition (CVD), plasma enhanced chemical vapor deposition (PECVD), physical vapor deposition (PVD), or the like, or a combination thereof. In one or more embodiments, the passivation layer 301 is formed by using ALD. The passivation layer 301 corresponds to the passivation layer 80 OF FIGS. 1 to 3.

As another example, the passivation layer 301, the first light-emitting structure 10, the second light-emitting structure 20, and the third light-emitting structure 30 may be sequentially formed on a substrate, and a resultant structure may be transferred to a transfer substrate to obtain a resultant structure of FIG. 7A. In this case, each of the first, second, and third light-emitting structures 10, 20, and 30 is epitaxially grown in the order of a p-type semiconductor layer, an active layer, and an n-type semiconductor layer.

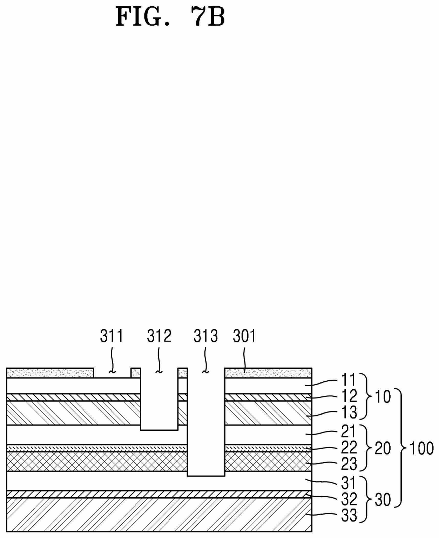

Referring to FIG. 7B, the passivation layer 301 and the epitaxial structure 100 are etched to form via holes 311, 312, and 313 through which the p-type semiconductor layer 11, 21, and 31 of the first, second, and third light-emitting structures 10, 20, and 30 are exposed. This process may be performed by using, for example, a dry etching process. The dry etching process may use, for example, inductively coupled plasma (ICP).

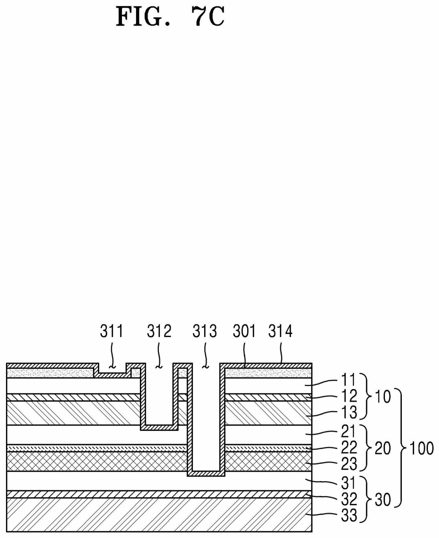

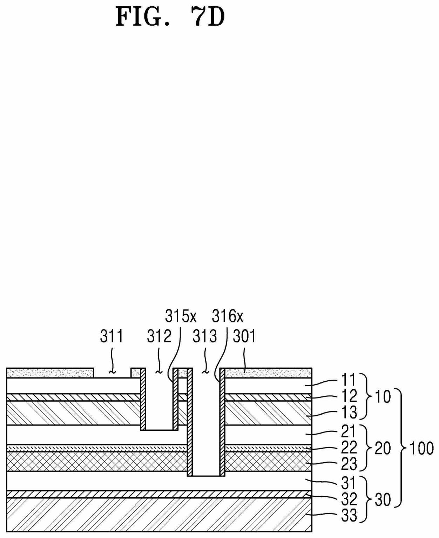

Referring to FIG. 7C, a dielectric material, for example, SiO₂, may be deposited on a surface of the passivation layer 301 and inner walls of the via holes 311, 312, and 313 to form a passivation 314. The passivation 314 on the surface of the passivation layer 301 and the bottoms of the via holes 311, 312, and 313 is removed by using, for example, a dry etching process, so that the passivation 314 on the inner walls of the via holes 312 and 313 remain. Accordingly, as shown in FIG. 7D, passivations 315x and 316x are formed on the inner walls of the via holes 312 and 313, and the passivations 315x and 316x correspond to the passivations 72x and 73x of FIGS. 1 to 3.

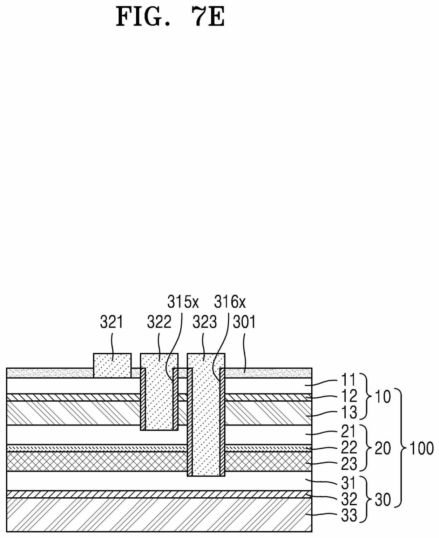

As shown in FIG. 7E, an electrode material is deposited and filled in the via holes 311, 312, and 313 to form electrodes 321, 322, and 323. The electrode material may include, for example, Al, Ti, Pt, Ag, Au, Pd, TiW, or any of various combinations thereof. The electrode material may include a transparent electrode material, for example, ITO. This process may be performed by using, for example, sputtering, atomic layer deposition (ALD), plasma enhanced atomic layer deposition (PEALD), chemical vapor deposition (CVD), plasma enhanced chemical vapor deposition (PECVD), physical vapor deposition (PVD), or the like, or a combination thereof. The electrodes 321, 322, and 323 respectively correspond to the first, second, and third p-electrodes 71, 72, and 73 in FIGS. 1 to 3.

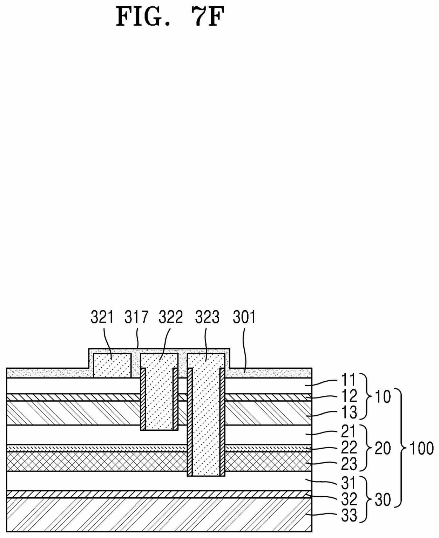

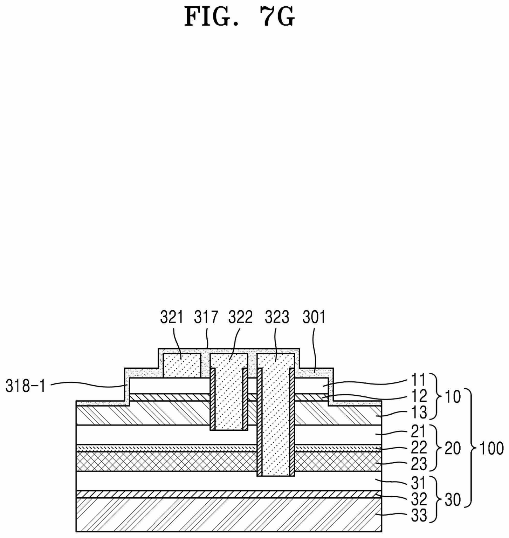

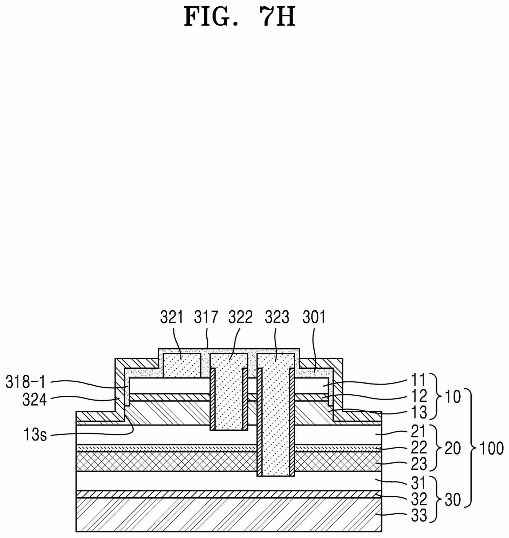

As shown in FIG. 7F, in order to protect the electrodes 321, 322, and 323 in a mesa etching process described below, for example, SiO₂ is deposited to form a protective mask 317 covering the electrodes 321, 322, and 323. As shown in FIG. 7G, the p-type semiconductor layer 11 and the active layer 12 of the first light-emitting structure 10 are mesa-etched. The etching may be performed by using, for example, a dry etching process or a wet etching process. The dry etching process may use, for example, inductively coupled plasma (ICP). The wet etching process may be performed by using, for example, a potassium hydroxide (KOH) solution or a tetramethyl ammonium hydroxide (TMAH) solution as an etching solution. A dielectric material is deposited on side surfaces of the p-type semiconductor layer 11 and the active layer 12 and a surface of the n-type semiconductor layer 13 which are exposed after the etching to form a passivation 318-1. In one or more embodiments, the passivation 318-1 is formed of SiO₂. Next, as shown in FIG. 7H, the n-type semiconductor layer 13 of the first light-emitting structure 10 is mesa-etched to expose the side surface 13s of the n-type semiconductor layer 13. Next, an electrode material is deposited to contact the side surface 13s of the n-type semiconductor layer 13 and extends in the stacking direction to cover the passivation 318-1, to form an electrode 324 partially covering a top surface of the passivation layer 301. The passivation 318-1 corresponds to the first separation layer 51 of FIGS. 1 to 3. A portion of the electrode 324 contacting the side surface 13s of the n-type semiconductor layer 13 corresponds to the first n-electrode portion 41 of FIGS. 1 to 3, and a portion covering an upper portion of the passivation layer 301 corresponds to the n-common portion 49 of FIGS. 1 to 3.

The processes of FIGS. 7F to 7H are sequentially performed on the second light-emitting structure 20 and the third light-emitting structure 30.

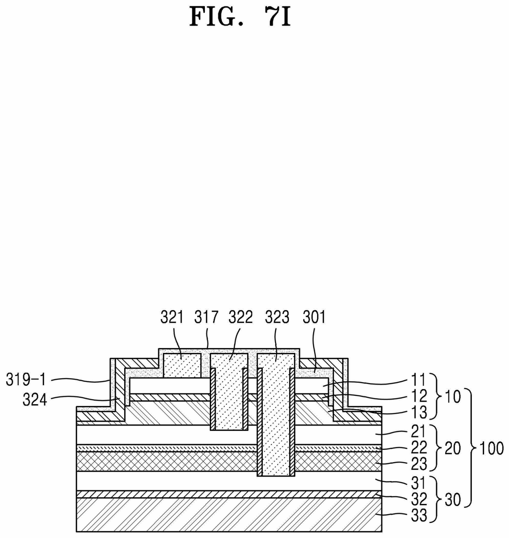

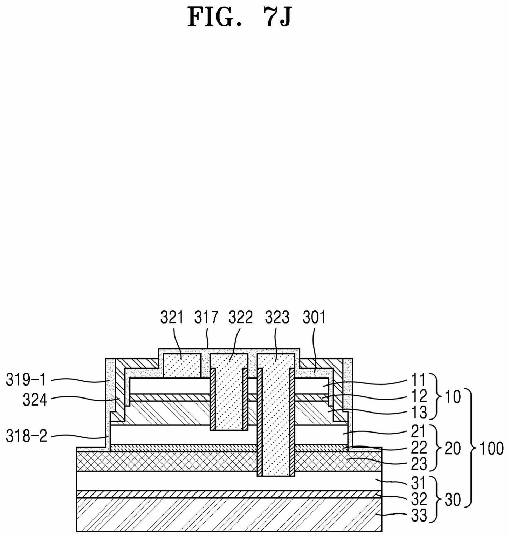

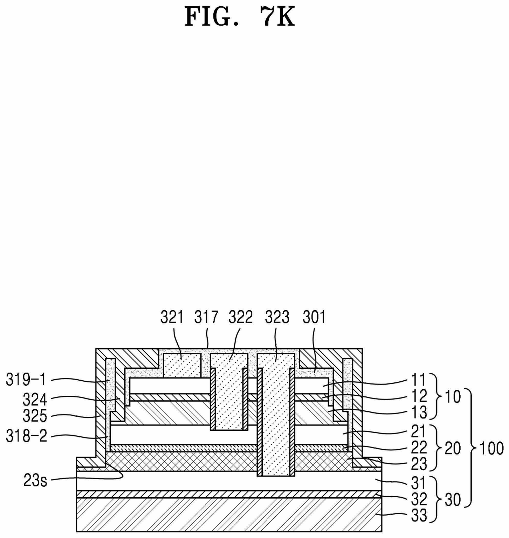

As shown in FIG. 7I, in order to protect the electrode 324 in a mesa etching process described below, for example, for example, SiO₂ is deposited to form a passivation 319-1 covering the electrode 324. As shown in FIG. 7J, the p-type semiconductor layer 21 and the active layer 22 of the second light-emitting structure 20 are mesa-etched. The etching may be performed by using a dry etching process or a wet etching process. A dielectric material, for example, SiO₂, is deposited on side surfaces of the p-type semiconductor layer 21 and the active layer 22 and a surface of the n-type semiconductor layer 23 which are exposed after the etching to form a passivation 318-2. Next, as shown in FIG. 7K, the n-type semiconductor layer 23 of the second light-emitting structure 20 is mesa-etched to expose the side surface 23s of the n-type semiconductor layer 23. Next, an electrode material is deposited to contact the side surface 23s of the n-type semiconductor layer 23 and extends in the stacking direction to cover the passivation 319-1, to form an electrode 325 connected to the portion of the electrode 324 covering the upper portion of the passivation layer 301. The passivation 319-1 corresponds to the first protective layer 61 of FIGS. 1 to 3. The passivation 318-2 corresponds to the second separation layer 52 of FIGS. 1 to 3. A portion of the electrode 325 contacting the side surface 23s of the n-type semiconductor layer 23 corresponds to the second n-electrode portion 42 of FIGS. 1 to 3, and a portion connected to the electrode 324 corresponds to the n-common portion 49 of FIGS. 1 to 3.

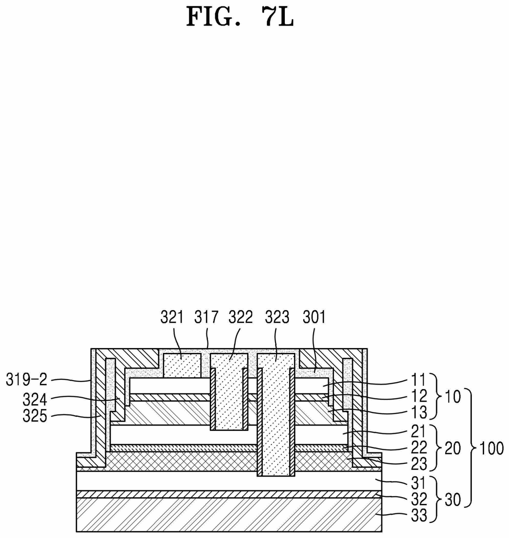

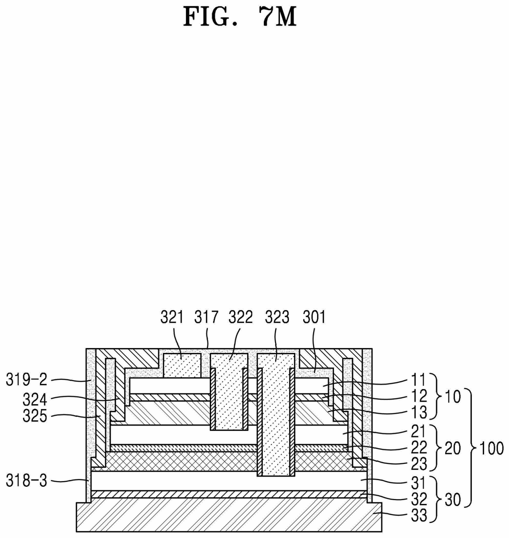

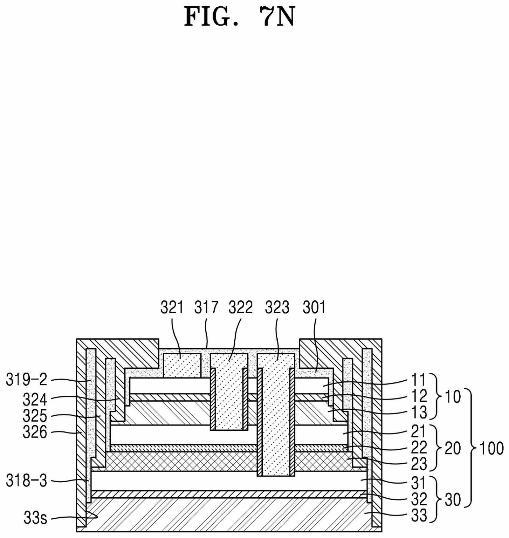

As shown in FIG. 7L, in order to protect the electrode 325 in a mesa etching process described below, for example, SiO₂ is deposited to form a passivation 319-2 covering the electrode 325. As shown in FIG. 7M, the p-type semiconductor layer 31 and the active layer 32 of the third light-emitting structure 30 are mesa-etched. The etching may be performed by using a dry etching process or a wet etching process. A dielectric material, for example, SiO₂, is deposited on side surfaces of the p-type semiconductor layer 31 and the active layer 32 and a surface of the n-type semiconductor layer 33 which are exposed after the etching to form a passivation 318-3. Next, as shown in FIG. 7N, the n-type semiconductor layer 33 of the third light-emitting structure 30 is mesa-etched to expose the side surface 33s of the n-type semiconductor layer 33. Next, an electrode material is deposited to contact the side surface 33s of the n-type semiconductor layer 33 and extends in the stacking direction to cover the passivation 319-2, to form an electrode 326 connected to a portion of the electrode 325 covering an upper portion of the passivation layer 301. The passivation 319-2 corresponds to the second protective layer 62 of FIGS. 1 to 3. The passivation 318-3 corresponds to the third separation layer 53 of FIGS. 1 to 3. A portion of the electrode 326 contacting the side surface 33s of the n-type semiconductor layer 33 corresponds to the third n-electrode portion 43 of FIGS. 1 to 3, and a portion connected to the electrode 325 corresponds to the n-common portion 49 of FIGS. 1 to 3.

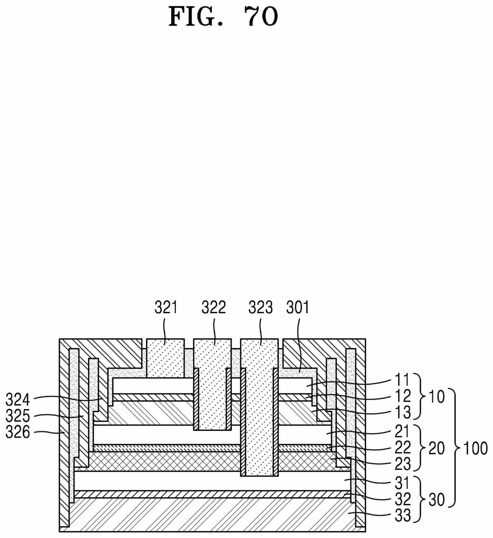

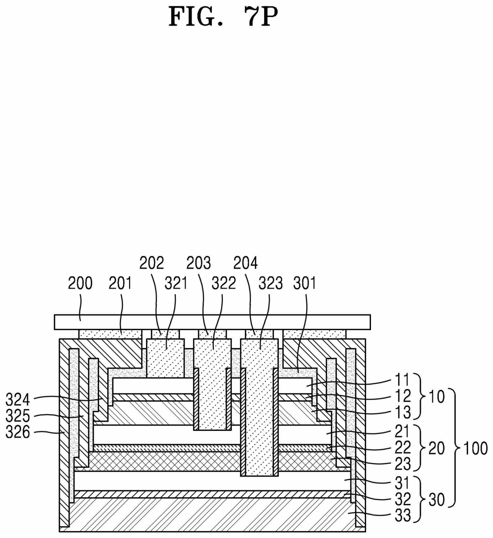

Next, as shown in FIG. 7O, the protective mask 317 is removed to expose the electrodes 321, 322, and 323. Next, as shown in FIG. 7P, portions of the electrodes 324, 325, and 326 located on a top surface of the passivation layer 301 and exposed portions of the electrodes 321, 322, and 323 are bonded to the bonding pads 201, 202, 203, and 204 of the substrate 200 of the display panel. Accordingly, the light-emitting device 1 of FIG. 1 may be manufactured.

As marked by a dashed line in FIG. 7A, when the epitaxial structure 100 is formed, insulating layers 302 and 303 may be respectively formed between the third light-emitting structure 30 and the second light-emitting structure 20 and between the second light-emitting structure 20 and the first light-emitting structure 10. The insulating layers 302 and 303 may be formed of, for example, a material that may be epitaxially grown together with the first, second, and third light-emitting structures 10, 20, and 30. For example, the insulating layers 91 and 92 may include AlGaN. The insulating layers 302 and 303 respectively correspond to the insulating layers 92 and 91 of FIG. 2. Next, the processes of FIGS. 7B to 7P may be performed to manufacture the light-emitting device 1a of FIG. 2.

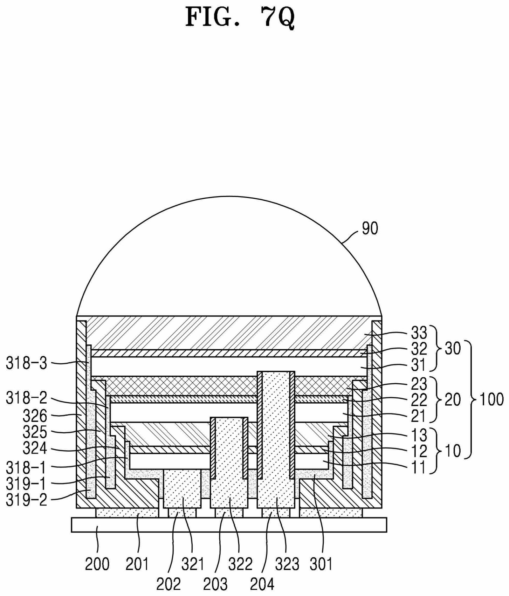

The lens 90 may be formed on the epitaxial structure 100. A method of forming the lens 90 is not particularly limited. In the state of FIG. 7P, the epitaxial structure 100 is turned over so that the third light-emitting structure 30 becomes an uppermost layer in the stacking direction as shown in FIG. 7Q. Next, a thermoplastic material is stacked on the third light-emitting structure 30 to form a light-transmitting layer. The thermoplastic material may include, for example, photoresist, polyester, acryl, or epoxy. A shape of the light-transmitting layer may be, for example, a cylindrical shape. Next, for example, a thermal reflow process may be performed to form the light-transmitting layer having a rectangular shape into a dome-shaped lens shape. A curvature of the lens 90 may be adjusted according to surface energy of a top surface of the third light-emitting structure 30, a contact angle of the light-transmitting layer, a thickness and a width of the light-transmitting layer, and a thermal reflow process temperature. Accordingly, the light-emitting device 1b of FIG. 3 may be manufactured.

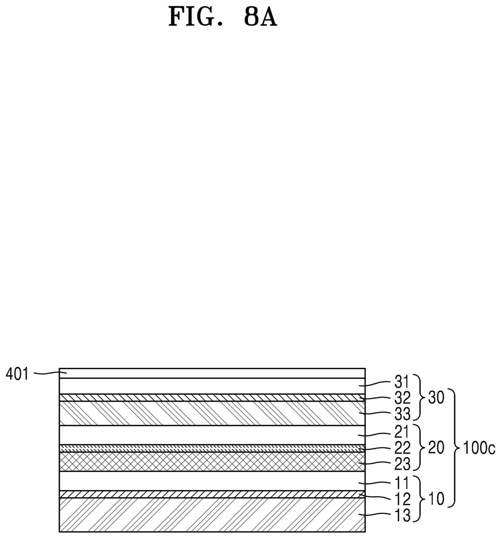

Hereinafter, a method of manufacturing an embodiment of the light-emitting device 1c of FIG. 5 will be described. FIGS. 8A to 8O illustrate an example of a method of manufacturing the light-emitting device 1c of FIG. 5.

First, as shown in FIG. 8A, the first, second, and third light-emitting structures 10, 20, and 30 are epitaxially grown on a growth substrate to form the epitaxial structure 100c, and a process of forming a passivation layer 401 on a top surface of the epitaxial structure 100c is performed. This process is the same as the process described with reference to FIG. 7A, and thus, a repeated description will be omitted. As another example, the passivation layer 401, the third light-emitting structure 30, the second light-emitting structure 20, and the first light-emitting structure 10 may be sequentially formed on a substrate, and a resultant structure may be transferred to a transfer substrate to obtain a resultant structure of FIG. 8A. In this case, each of the first, second, and third light-emitting structures 10, 20, and 30 is epitaxially grown in the order of a p-type semiconductor layer, an active layer, and an n-type semiconductor layer.

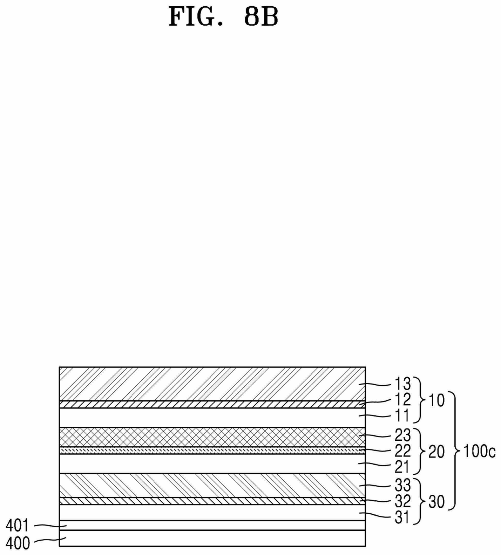

Referring to FIG. 8B, a dummy substrate 400 is bonded to the passivation layer 401 of the resultant structure of FIG. 8A and then is turned over, and the grown substrate is removed. Next, an exposed top surface of the first light-emitting structure 10 is ground and planarized.

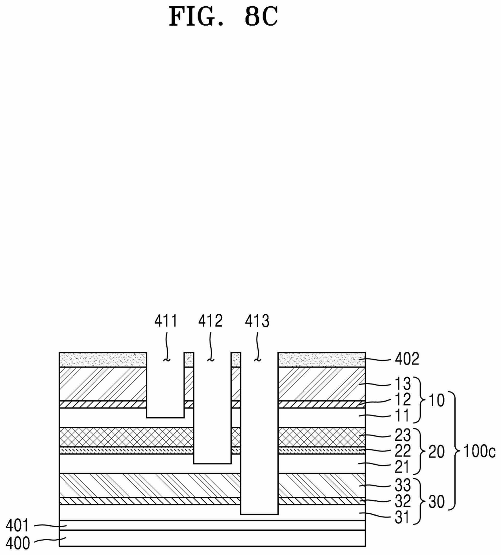

Referring to FIG. 8C, a dielectric material is deposited on the top surface of the first light-emitting structure 10 to form a protective mask layer 402. The dielectric material may include, for example, SiO₂, TiO₂, Si₃N₄, AlOₓ, AlOₓN_{y}, Ta₂O₅, TiN, AlN, ZrO₂, TiAlN, TiSiN, HfOₓ, or any of various combinations thereof. In one or more embodiments, the protective mask layer 402 is formed of SiO₂, which is a light-transmitting dielectric material. For example, the protective mask layer 402 may be formed by using, for example, sputtering, atomic layer deposition (ALD), plasma enhanced atomic layer deposition (PEALD), chemical vapor deposition (CVD), plasma enhanced chemical vapor deposition (PECVD), physical vapor deposition (PVD), or the like, or a combination thereof. In one or more embodiments, the protective mask layer 402 is formed by using ALD.

Next, the protective mask layer 402 and the epitaxial structure 100c are etched to form via holes 411, 412, and 413 through which the p-type semiconductor layers 11, 21, and 31 of the first, second, and third light-emitting structures 10, 20, and 30 are exposed. This process may be performed by using, for example, a dry etching process. The dry etching process may use, for example, inductively coupled plasma (ICP).

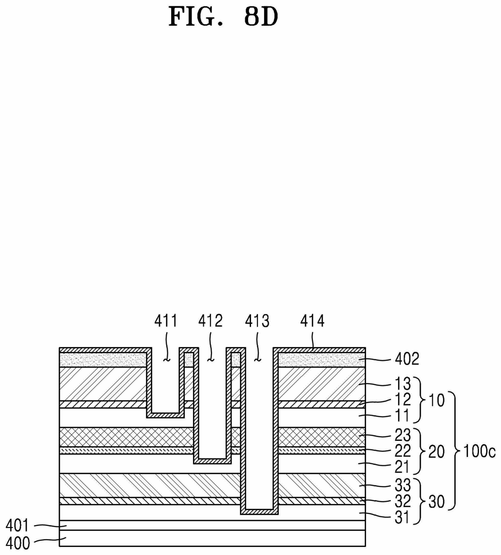

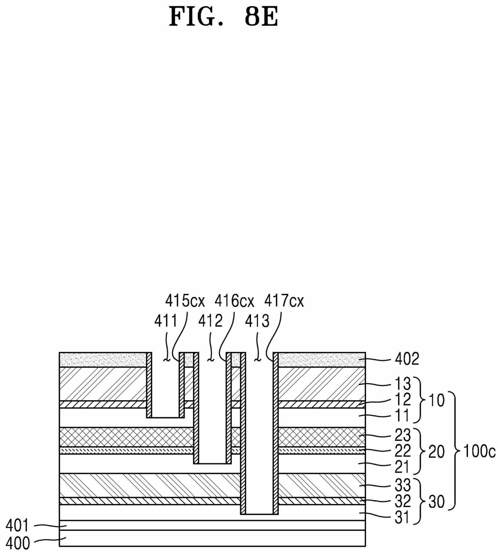

Referring to FIG. 8D, a dielectric material, for example, SiO₂, may be deposited on a surface of the protective mask layer 402 and inner walls of the via holes 411, 412, and 413 to form a passivation 414. The passivation 414 on the surface of the protective mask layer 402 and the bottoms of the via holes 411, 412, and 413 is removed by using, for example, a dry etching process so that the passivation 414 on the inner walls of the via holes 411, 412, and 413 remains. Accordingly, as shown in FIG. 8E, passivations 415x, 416x, and 417x are formed on the inner walls of the via holes 411, 412, and 413, and the passivations 415x, 416x, and 417x correspond to the passivations 71cx, 72cx, and 73cx of FIG. 5.

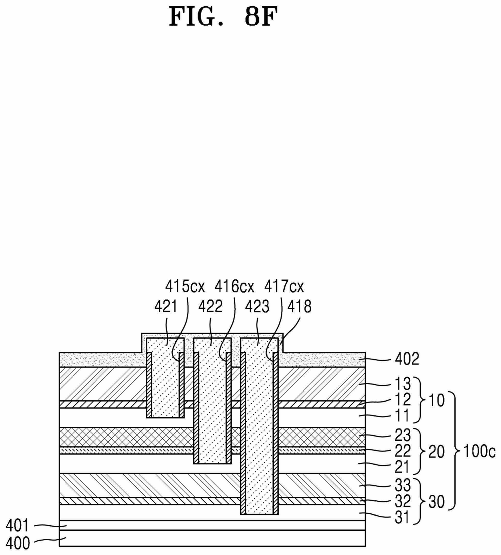

As shown in FIG. 8F, an electrode material is deposited and filled in the via holes 411, 412, and 413 to form electrodes 421, 422, and 423. The electrode material may include, for example, Al, Ti, Pt, Ag, Au, Pd, TiW, or any of various combinations thereof. The electrode material may include a transparent electrode material, for example, ITO. This process may be performed by using, for example, sputtering, atomic layer deposition (ALD), plasma enhanced atomic layer deposition (PEALD), chemical vapor deposition (CVD), plasma enhanced chemical vapor deposition (PECVD), physical vapor deposition (PVD), or the like, or a combination thereof. The electrodes 421, 422, and 423 respectively correspond to the first, second, and third p-electrodes 71c, 72c, and 73c of FIG. 5. Next, in order to protect the electrodes 421, 422, and 423 in a mesa etching process described below, for example, SiO₂ is deposited to form a passivation layer 418 covering the electrodes 421, 422, and 423. The passivation layer 418 corresponds to the passivation layer 80 of FIG. 5.

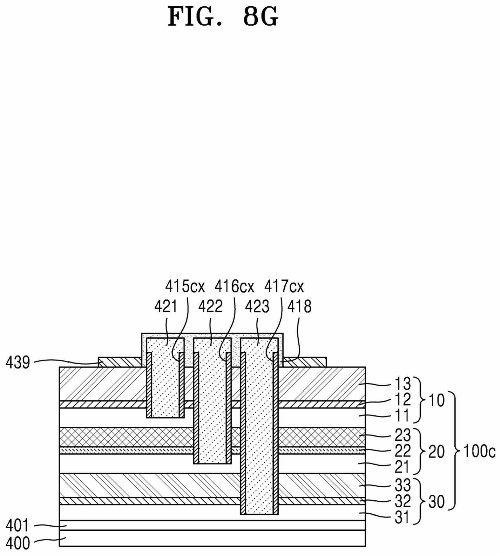

As shown in FIG. 8G, the protective mask layer 402 formed on the top surface of the first light-emitting structure 10 is partially removed to expose a top surface of the n-type semiconductor layer 13 of the first light-emitting structure 10. Next, an electrode material is deposited on the exposed top surface of the n-type semiconductor layer 13 to form an electrode 439. The electrode material may include, for example, Al, Ti, Pt, Ag, Au, Pd, TiW, or any of various combinations thereof. The electrode material may include a transparent electrode material, for example, ITO. The electrode 439 corresponds to the n-common portion 49c of FIG. 5 and also functions as the first n-electrode portion 41 of FIG. 3.

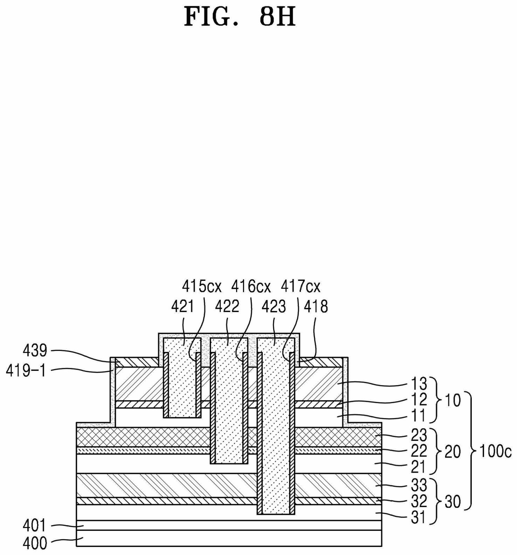

As shown in FIG. 8H, the n-type semiconductor layer 13, the active layer 12, and the p-type semiconductor layer 11 of the first light-emitting structure 10 are mesa-etched. The etching may be performed by using a dry etching process or a wet etching process. The dry etching process may use, for example, inductively coupled plasma (ICP). The wet etching process may be performed by using a potassium hydroxide (KOH) solution or a tetramethyl ammonium hydroxide (TMAH) solution as an etching solution. A dielectric material is deposited on side surfaces of the n-type semiconductor layer 13, the active layer 12, and the p-type semiconductor layer 11 of the first light-emitting structure 10 and a surface of the n-type semiconductor layer 23 of the second light-emitting structure 20 which are exposed after the etching to form a passivation 419-1. In one or more embodiments, the passivation 419-1 is formed of SiO₂.

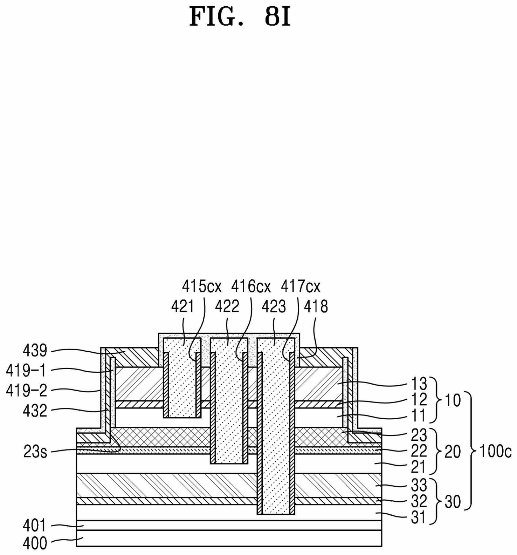

Next, as shown in FIG. 8I, the passivation layer 419-1 on the surface of the n-type semiconductor layer 23 of the second light-emitting structure 20 and the n-type semiconductor layer 23 of the second light-emitting structure 20 are mesa-etched to expose the side surface 23s of the n-type semiconductor layer 23. Next, an electrode material is deposited to contact the side surface 23s of the n-type semiconductor layer 23 and extends in the stacking direction to form an electrode 432 stacked to an upper portion of the electrode 439. The passivation 419-1 corresponds to the first separation layer 51c of FIG. 5. A portion of the electrode 432 contacting the side surface 13s of the n-type semiconductor layer 13 corresponds to the second n-electrode portion 42c of FIG. 5, and a portion covering the upper portion of the electrode 439 corresponds to the n-common portion 49c of FIG. 5 together with the electrode 439. Next, in order to protect the electrode 432 in a mesa etching process described below, for example, SiO₂ is deposited to form a passivation 419-2 covering the electrode 432.

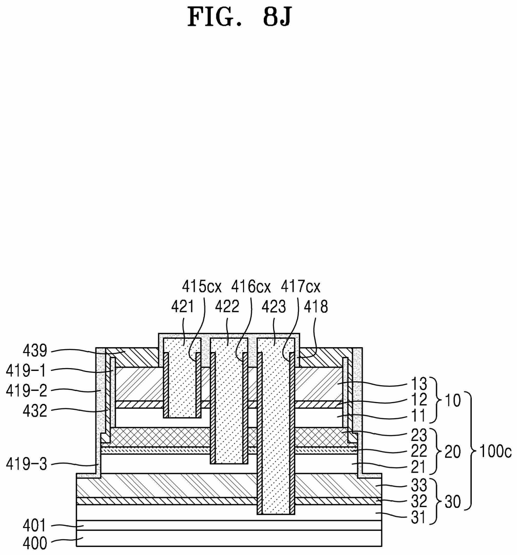

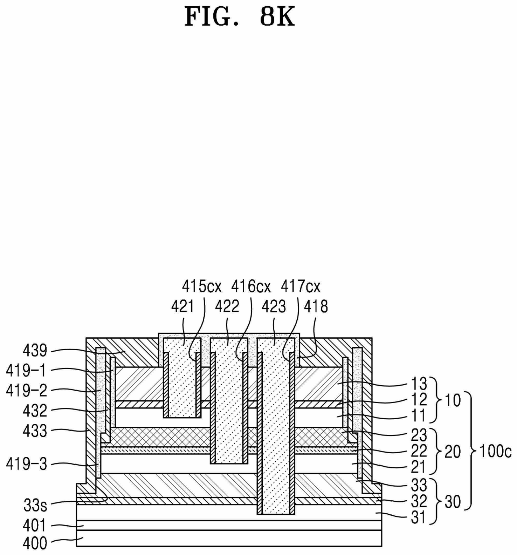

As shown in FIG. 8J, portions of the electrode 432 and the passivation 419-2 on the n-type semiconductor layer 23 of the second light-emitting structure 20 and the active layer 22 and the p-type semiconductor layer 21 of the second light-emitting structure 20 are mesa-etched. The etching may be performed by using, for example, a dry etching process or a wet etching process. A dielectric material, for example, SiO₂, is deposited on side surfaces of the active layer 22 and the p-type semiconductor layer 21 and a surface of the n-type semiconductor layer 33 of the third light-emitting structure 30 which are exposed after the etching to form a passivation 419-3. Next, as shown in FIG. 8K, the n-type semiconductor layer 33 of the third light-emitting structure 30 is mesa-etched to expose the side surface 33s of the n-type semiconductor layer 33. Next, an electrode material is deposited to contact the side surface 33s of the n-type semiconductor layer 33 and extends in the stacking direction, to form an electrode 433 connected to the electrode 439. The passivation 419-2 corresponds to the protective layer 60c of FIG. 5. The passivation 419-3 corresponds to the second separation layer 52c of FIG. 5. The electrode 433 corresponds to the third n-electrode portion 43c of FIG. 5.

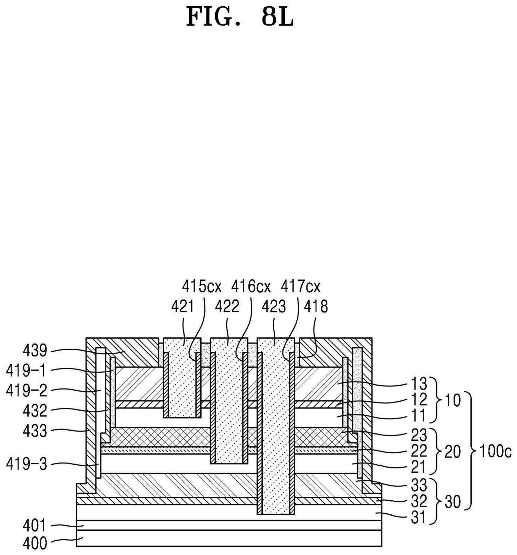

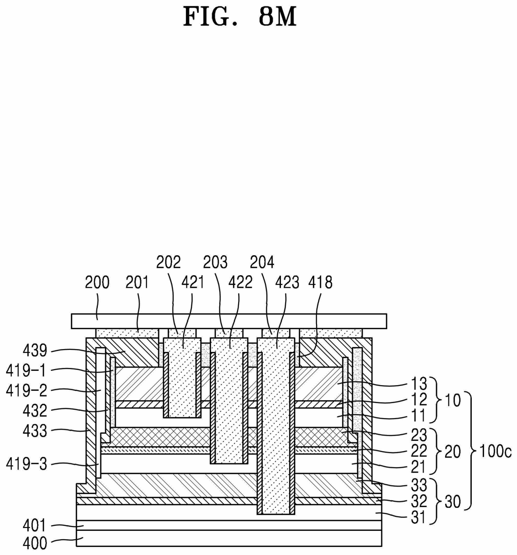

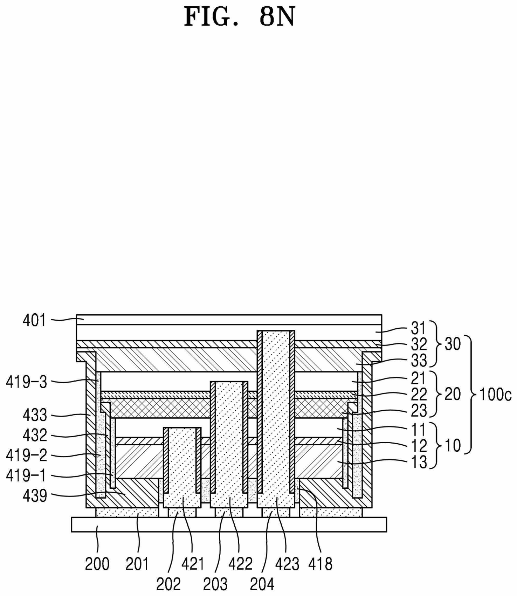

Next, as shown in FIG. 8L, a part of the passivation layer 418 is removed to expose the electrodes 421, 422, and 423. Next, as shown in FIG. 8M, portions of the electrodes 432,433, and 439 located on a top surface of the passivation layer 418 and exposed portions of the electrodes 421, 422, and 423 are bonded to the bonding pads 201, 202, 203, and 204 of the substrate 200 of the display panel. In the state of FIG. 8M, the epitaxial structure 100c is turned over so that the third light-emitting structure 30 becomes an uppermost layer in the stacking direction as shown in FIG. 8N. Next, the dummy substrate 400 is removed.

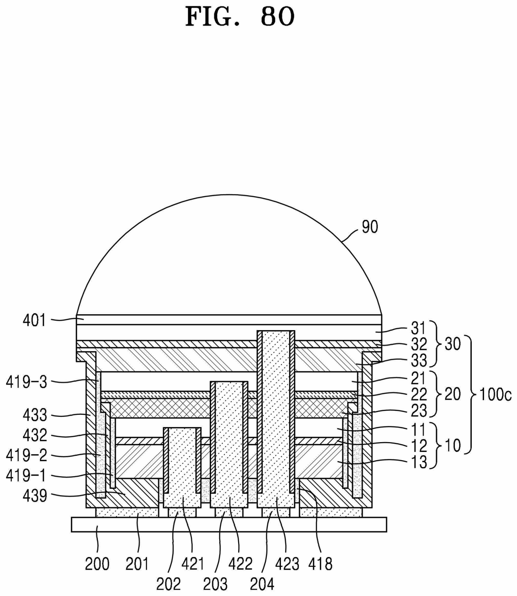

Next, the lens 90 may be formed on the epitaxial structure 100c. A method of forming the lens 90 is not particularly limited. Referring to FIG. 8O, a thermoplastic material is stacked on the passivation layer 401 on the third light-emitting structure 30 to form a light-transmitting layer. For example, the thermoplastic material may include photoresist, polyester, acryl or epoxy. A shape of the light-transmitting layer may be, for example, a cylindrical shape. Next, for example, a thermal reflow process may be performed to form the light-transmitting layer having a rectangular shape into a dome-shaped lens shape. A curvature of the lens 90 may be adjusted according to surface energy of a top surface of the passivation layer 401, a contact angle of the light-transmitting layer, a thickness and a width of the light-transmitting layer, and a thermal reflow process temperature. Accordingly, the light-emitting device 1c of FIG. 5 may be manufactured.

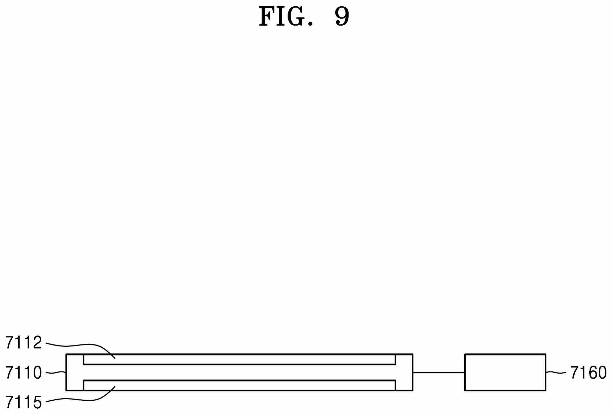

FIG. 9 is a schematic view illustrating an embodiment of a display apparatus. Referring to FIG. 9, a display apparatus may include a display panel 7110 and a controller 7160. The display panel 7110 includes a light-emitting structure 7112 and a driving circuit 7115 for switching the light-emitting structure 7112 on/off. The light-emitting structure 7112 may include a plurality of light-emitting devices described with reference to FIGS. 1 to 6. The plurality of light-emitting devices may be arranged, for example, in a two-dimensional array. The driving circuit 7115 includes a plurality of switching devices for individually switching the plurality of light-emitting devices on/off. The controller 7160 inputs an on/off switching signal of the plurality of light-emitting devices to the driving circuit 7115 according to an image signal.

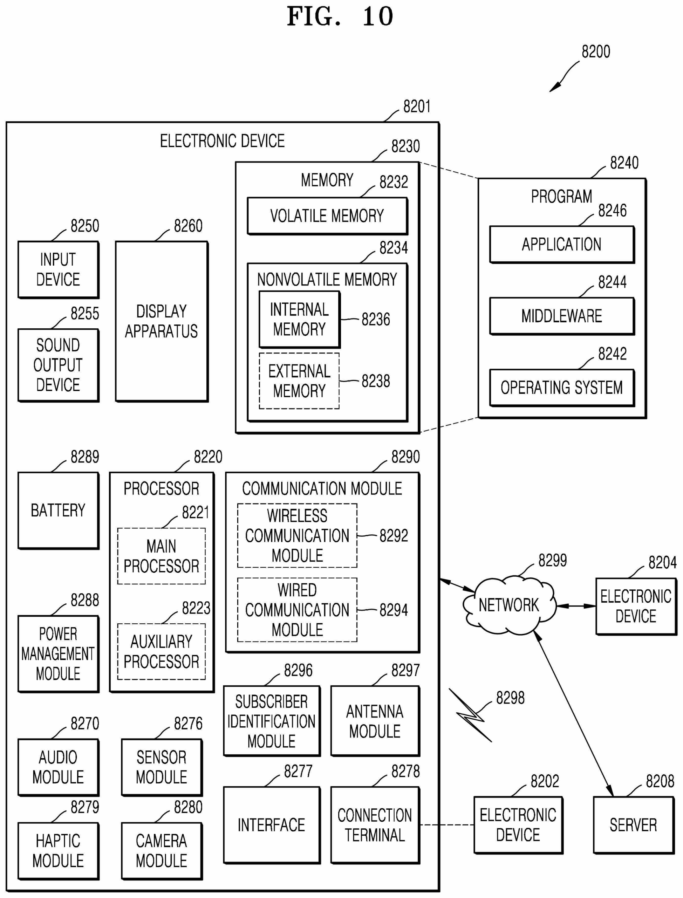

FIG. 10 is a block diagram illustrating an embodiment of an electronic device including a display. Referring to FIG. 10, an electronic device 8201 may be provided in a network environment 8200. In the network environment 8200, the electronic device 8201 may communicate with another electronic device 8202 through a first network 8298 (e.g., a short-range wireless communication network), or may communicate with another electronic device 8204 and/or a server 8208 through a second network 8299 (e.g., a long-range wireless communication network). The electronic device 8201 may communicate with the electronic device 8204 through the server 8208. The electronic device 8201 may include a processor 8220, a memory 8230, an input device 8250, a sound output device 8255, a display apparatus 8260, an audio module 8270, a sensor module 8276, an interface 8277, a haptic module 8279, a camera module 8280, a power management module 8288, a battery 8289, a communication module 8290, a subscriber identification module 8296, and/or an antenna module 8297. Some of these elements may be omitted from the electronic device 8201, or other elements may be added to the electronic device 8201. Some of these elements may be implemented as one integrated circuit. For example, the sensor module 8276 (e.g., a fingerprint sensor, an iris sensor, or an illuminance sensor) may be embedded in the display apparatus 8260 (e.g., a display).

The processor 8220 may execute software (e.g., a program 8240) to control one or more other elements (e.g., hardware or software elements) in the electronic device 8201 connected to the processor 8220, and may perform various data processing or operations. As part of the data processing or operations, the processor 8220 may load commands and/or data received from other elements (e.g., the sensor module 8276 and the communication module 8290) into a volatile memory 8232, may process the commands and/or data stored in the volatile memory 8232, and may store resulting data in a nonvolatile memory 8234. The processor 8220 may include a main processor 8221 (e.g., a central processing unit or an application processor) and an auxiliary processor 8223 (e.g., a graphics processing unit, an image signal processor, a sensor hub processor, or a communication processor) which may operate independently or together with the main processor 8221. The auxiliary processor 8223 may use less power than the main processor 8221 and may perform a specialized function.

The auxiliary processor 8223 may operate on behalf of the main processor 8221 while the main processor 8221 is in an inactive state (e.g., a sleep state), or together with the main processor 8221 while the main processor 8221 is in an active state (e.g., an application execution state), to control functions and/or states related to some (e.g., the display apparatus 8260, the sensor module 8276, and the communication module 8290) of the elements of the electronic device 8201. The auxiliary processor 8223 (e.g., an image signal processor or a communication processor) may be implemented as a part of other functionally related elements (e.g., the camera module 8280 and the communication module 8290).

The memory 8230 may store various data required by elements (e.g., the processor 8220 and the sensor module 8276) of the electronic device 8201. The data may include, for example, input data and/or output data for software (e.g., the program 8240) and related commands. The memory 8230 may include the volatile memory 8232 and/or the nonvolatile memory 8234.

The program 8240 may be stored as software in the memory 8230, and may include an operating system 8242, a middleware 8244, and/or an application 8246.

The input device 8250 may receive commands and/or data to be used by an element (e.g., the processor 8220) of the electronic device 8201 from the outside (e.g., a user) of the electronic device 8201. The input device 8250 may include a remote controller, a microphone, a mouse, a keyboard, and/or a digital pen (e.g., a stylus pen).

The sound output device 8255 may output a sound signal to the outside of the electronic device 8201. The sound output device 8255 may include a speaker and/or a receiver. The speaker may be used for general purposes such as multimedia playback or recording playback, and the receiver may be used to receive an incoming call. The receiver may be coupled as a part of the speaker, or may be implemented as an independent separate device.

The display apparatus 8260 may visually provide information to the outside of the electronic device 8201. The display apparatus 8260 may include a display, a hologram device, or a projector, and a control circuit for controlling a corresponding device. The display apparatus 8260 may include the display described with reference to FIG. 9. The display apparatus 8260 may include touch circuitry configured to sense a touch, and/or a sensor circuit (e.g., a pressure sensor) configured to measure an intensity of a force generated by the touch.

The audio module 8270 may convert sound into an electrical signal, or may convert an electrical signal into sound. The audio module 8270 may obtain sound through the input device 8250, or may output sound through the sound output device 8255 and/or a speaker and/or a headphone of another electronic device (e.g., the electronic device 8202) connected directly or wirelessly to the electronic device 8201.

The sensor module 8276 may detect an operating state (e.g., power or a temperature) of the electronic device 8201 or an external environment state (e.g., a user state), and may generate an electrical signal and/or a data value corresponding to the detected state. The sensor module 8276 may include a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface 8277 may support one or more designated protocols that may be used to directly or wirelessly connect the electronic device 8201 to another electronic device (e.g., the electronic device 8202). The interface 8277 may include a high-definition multimedia interface (HDMI), a universal serial bus (USB) interface, a secure digital (SD) card interface, and/or an audio interface.

A connection terminal 8278 may include a connector through which the electronic device 8201 may be physically connected to another electronic device (e.g., the electronic device 8202). The connection terminal 8278 may include an HDMI connector, a USB connector, an SD card connector, and/or an audio connector (e.g., headphone connector).

The haptic module 8279 may convert an electrical signal into a mechanical stimulus (e.g., a vibration or a motion) or an electrical stimulus that may be perceived by a user through tactile or kinesthetic sense. The haptic module 8279 may include a motor, a piezoelectric element, and/or an electrical stimulation device.

The camera module 8280 may capture a still image and a moving image. The camera module 8280 may include a lens assembly including one or more lenses, image sensors, image signal processors, and/or flashes. The lens assembly included in the camera module 8280 may collect light emitted from a subject whose image is captured.

The power management module 8288 may manage power supplied to the electronic device 8201. The power management module 8288 may be implemented as a part of a power management integrated circuit (PMIC).

The battery 8289 may supply power to elements of the electronic device 8201. The battery 8289 may include a non-rechargeable primary cell, a rechargeable secondary cell, and/or a fuel cell.

The communication module 8290 may support establishment of a direct (wired) communication channel and/or a wireless communication channel between the electronic device 8201 and another electronic device (e.g., the electronic device 8202, the electronic device 8204, or the server 8208), and communication through the established communication channel. The communication module 8290 may include one or more communication processors that operate independently of the processor 8220 (e.g., an application processor) and support direct communication and/or wireless communication. The communication module 8290 may include a wireless communication module 8292 (e.g., a cellular communication module, a short-range wireless communication module, or a global navigation satellite system (GNSS) communication module) and/or a wired communication module 8294 (e.g., a local area network (LAN) communication module or a power line communication module). A corresponding communication module from among the communication modules may communicate with another electronic device through the first network 8298 (e.g., a short-range communication network such as Bluetooth, WiFi Direct, or infrared data association (IrDA)) or the second network 8299 (e.g., a long-range communication network such as a cellular network, the Internet, or a computer network (e.g., a LAN or a wide area network (WAN)). The various types of communication modules may be integrated into one element (e.g., a single chip), or may be implemented as a plurality of separate elements (e.g., a plurality of chips). The wireless communication module 8292 may identify and authenticate the electronic device 8201 within a communication network such as the first network 8298 and/or the second network 8299 by using subscriber information (e.g., international mobile subscriber identity (IMSI)) stored in the subscriber identification module 8296.

The antenna module 8297 may transmit a signal and/or power to the outside (e.g., another electronic device) or may receive a signal and/or power from the outside. An antenna may include a radiator including a conductive pattern formed on a substrate (e.g., a printed circuit board (PCB)). The antenna module 8297 may include one antenna or a plurality of antennas. When the antenna module 8297 includes a plurality of antennas, an antenna suitable for a communication method used in a communication network such as the first network 8298 and/or the second network 8299 may be selected from among the plurality of antennas by the communication module 8290. A signal and/or power may be transmitted or received between the communication module 8290 and another electronic device through the selected antenna. Another component (e.g., a radio-frequency integrated circuit (RFIC)) other than the antenna may be included as a part of the antenna module 8297.

Some of the elements may be connected to one another through a communication method (e.g., a bus, a general-purpose input and output (GPIO), a serial peripheral interface (SPI), or a mobile industry processor interface (MIPI)) between peripheral devices, and may exchange signals (e.g., commands or data).

Commands or data may be transmitted or received between the electronic device 8201 and the external electronic device 8204 through the server 8208 connected to the second network 8299. The electronic devices 8202 and 8204 may be the same or different type of devices as or from the electronic device 8201. All or some of operations executed by the electronic device 8201 may be performed by at least one of the other electronic devices 8202, 8204, and 8208. For example, when the electronic device 8201 should perform certain functions or services, the electronic device 8201 may transmit a request to one or more other electronic devices to perform some or all of the functions or services, instead of directly performing the functions or services. The other electronic devices receiving the request may execute additional functions or services related to the request, and may transmit a result of the execution to the electronic device 8201. To this end, cloud computing, distributed computing, and/or client-server computing may be used.

The electronic device 8201 may be applied to various devices. Various elements of the electronic device 8201 may be appropriately modified according to a function of the device, and elements suitable to perform a function of the device may be added. Hereinafter, application examples of the electronic device 8201 will be described.

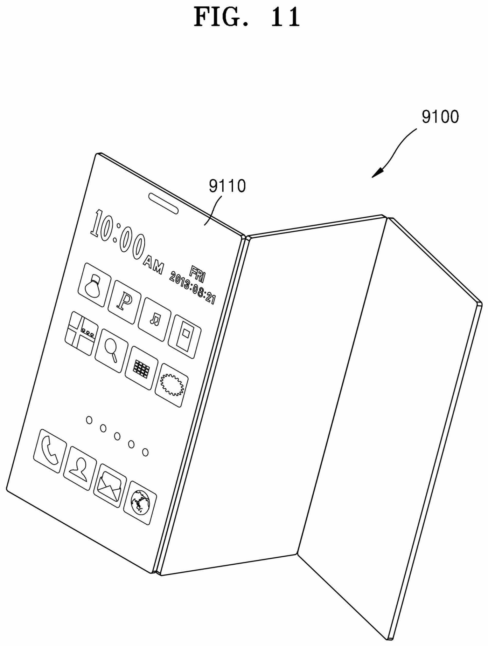

FIG. 11 illustrates an embodiment of a mobile device as an application example of an electronic device is applied. A mobile device 9100 may include a display apparatus 9110. The display apparatus 9110 may include the display apparatus described with reference to FIG. 9. The display apparatus 9110 may have a foldable structure, for example, a multi-foldable structure.

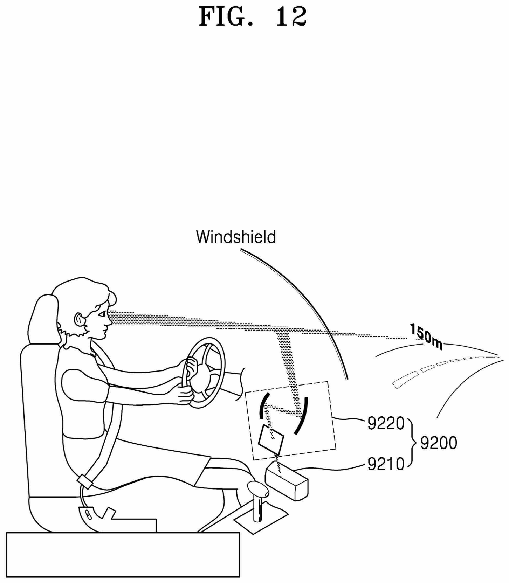

FIG. 12 illustrates an embodiment of a head-up display apparatus for a vehicle as an application example of an electronic device. A head-up display apparatus 9200 for a vehicle may include a display 9210 provided in an area of the vehicle, and an optical path changing member 9220 configured to change a path of light so that a driver may see an image generated on the display 9210. The display 9210 may include the display apparatus described with reference to FIG. 9.

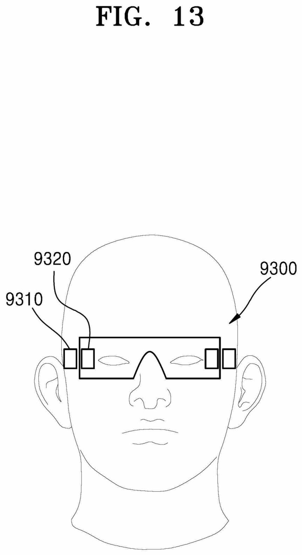

FIG. 13 illustrates an embodiment of augmented reality glasses or virtual reality glasses as an application example of an electronic device. Augmented reality glasses (or virtual reality glasses) 9300 may include a projection system 9310 that forms an image, and an element 9320 that guides an image from the projection system 9310 into a user's eyes. The projection system 9310 may include the display apparatus described with reference to FIG. 9.

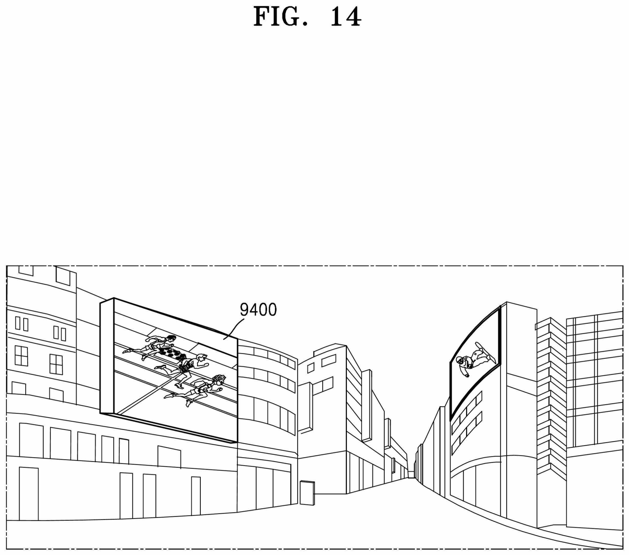

FIG. 14 illustrates an embodiment of a large signage as an application example of an electronic device. A signage 9400 may include the display apparatus described with reference to FIG. 9. The signage 9400 may be used for outdoor advertisement using a digital information display, and may control advertisement content or the like through a communication network. The signage 9400 may be implemented through, for example, the electronic device described with reference to FIG. 12.

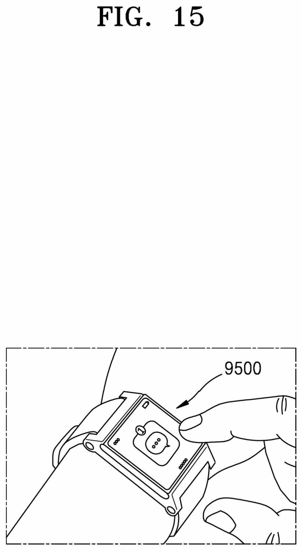

FIG. 15 illustrates an embodiment of a wearable display as an application example of an electronic device. A wearable display 9500 may include the display apparatus described with reference to FIG. 9. The wearable display 9500 may be implemented through the electronic device described with reference to FIG. 10.

A light-emitting device or a display including the light-emitting device according to an embodiment may also be applied to various other products such as a rollable TV and a stretchable display.

According to embodiments, a light-emitting device with improved luminous efficiency by reducing the number of electrodes having a conductive via structure and a display apparatus including the light-emitting device may be implemented.

In addition, embodiments of the present application are defined in the following clauses:
Clause 1. A light-emitting device comprising:
   an epitaxial structure comprising a first light-emitting structure, a second light-emitting structure, and third light-emitting structure which are sequentially stacked in a vertical direction and configured to emit light of different wavelengths, a width of the first light-emitting structure being less than a width of the second light-emitting structure, the width of the second light-emitting structure being less than a width of third light-emitting structure in a horizontal direction orthogonal to the vertical direction, each of the first light-emitting structure, the second light-emitting structure, and the third light-emitting structure comprising a p-type semiconductor layer, an active layer, and an n-type semiconductor layer which are sequentially stacked;
   a first p-electrode contacting the p-type semiconductor layer of the first light-emitting structure;
   a second p-electrode contacting the p-type semiconductor layer of the second light-emitting structure;
   a third p-electrode contacting the p-type semiconductor layer of the third light-emitting structure, at least one of the first p-electrode, the second p-electrode, and the third p-electrode having a conductive via structure;
   an n-common electrode comprising an n-common portion under the epitaxial structure, and n-electrode portions extending from the n-common portion and contacting a side surface of the n-type semiconductor layer of each of the first light-emitting structure, the second light-emitting structure, and the third light-emitting structure, at least two of the n-electrode portions being on a side portion of the epitaxial structure and spaced apart from each other in the horizontal direction; and
   a separation layer between the n-common electrode and side surfaces of the p-type semiconductor layer and the active layer of each of the first light-emitting structure, the second light-emitting structure, and the third light-emitting structure.
Clause 2. The light-emitting device of clause 1, wherein, in each of the first light-emitting structure, the second light-emitting structure, and the third light-emitting structure, the p-type semiconductor layer, the active layer, and the n-type semiconductor layer are sequentially stacked.
Clause 3. The light-emitting device of clause 2, wherein a width of the active layer and a width of the p-type semiconductor layer of each of the first light-emitting structure, the second light-emitting structure, and the third light-emitting structure are less than a width of the n-type semiconductor layer in the horizontal direction, and
   wherein the n-electrode portions comprise a first n-electrode portion, a second n-electrode portion, and a third n-electrode portion on the side portion of the epitaxial structure and spaced apart from each other in the horizontal direction, the first n-electrode portion contacts the side surface of the n-type semiconductor layer of the first light-emitting structure, the second n-electrode portion contacts the side surface of the n-type semiconductor layer of the second light-emitting structure, and the third n-electrode portion contacts the side surface of the n-type semiconductor layer of the third light-emitting structure.
Clause 4. The light-emitting device of clause 3, wherein the separation layer comprises:
   a first separation layer between the first n-electrode portion and the side surfaces of the p-type semiconductor layer and the active layer of the first light-emitting structure;
   a second separation layer between the second n-electrode portion and the side surfaces of the p-type semiconductor layer and the active layer of the second light-emitting structure; and
   a third separation layer between the third n-electrode portion and the side surfaces of the p-type semiconductor layer and the active layer of the third light-emitting structure.
Clause 5. The light-emitting device of clause 3, further comprising:
   a first protective layer between the first n-electrode portion and the second n-electrode portion; and
   a second protective layer between the second n-electrode portion and the third n-electrode portion.
Clause 6. The light-emitting device of clause 2, wherein the first p-electrode contacts the p-type semiconductor layer of the first light-emitting structure,
   wherein the second p-electrode passes through the first light-emitting structure and contacts the p-type semiconductor layer of the second light-emitting structure, and
   wherein the third p-electrode passes through the first light-emitting structure and the second light-emitting structure and contacts the p-type semiconductor layer of the third light-emitting structure.
Clause 7. The light-emitting device of clause 2, wherein the first light-emitting structure is configured to emit red light, and one of the second light-emitting structure and the third light-emitting structure is configured to emit blue light and the other one of the second light-emitting structure and the third light-emitting structure is configured to emit green light.
Clause 8. The light-emitting device of clause 1, wherein, in each of the first light-emitting structure, the second light-emitting structure, and the third light-emitting structure, the n-type semiconductor layer, the active layer, and the p-type semiconductor layer are sequentially stacked.
Clause 9. The light-emitting device of clause 8, wherein, in each of the second light-emitting structure and the third light-emitting structure, a width of the n-type semiconductor layer is less than a width of the active layer and a width of the p-type semiconductor layer in the horizontal direction,
   wherein the n-common electrode contacts a bottom surface of the n-type semiconductor layer of the first light-emitting structure, and
   wherein the n-electrode portions comprise a second n-electrode portion and a third n-electrode portion on the side portion of the epitaxial structure spaced apart from each other in the horizontal direction, the second n-electrode portion contacts the side surface of the n-type semiconductor layer of the second light-emitting structure, and the third n-electrode portion contacts the side surface of the n-type semiconductor layer of the third light-emitting structure.
Clause 10. The light-emitting device of clause 9, wherein the separation layer comprises:
   a first separation layer between the second n-electrode portion and the side surfaces of the n-type semiconductor layer, the active layer, and the p-type semiconductor layer of the first light-emitting structure; and
   a second separation layer between the third n-electrode portion and the side surfaces of the p-type semiconductor layer and the active layer of the second light-emitting structure.
Clause 11. The light-emitting device of clause 10, wherein the first separation layer partially extends from the p-type semiconductor layer of the first light-emitting structure to the n-type semiconductor layer of the second light-emitting structure, and
   wherein the second separation layer partially extends from the p-type semiconductor layer of the second light-emitting structure to the n-type semiconductor layer of the third light-emitting structure.
Clause 12. The light-emitting device of clause 9, further comprising a protective layer between the second n-electrode portion and the third n-electrode portion.
Clause 13. The light-emitting device of clause 9, wherein the first p-electrode passes through the n-type semiconductor layer and the active layer of the first light-emitting structure and contacts the p-type semiconductor layer of the first light-emitting structure,
   wherein the second p-electrode passes through the first light-emitting structure and the n-type semiconductor layer and the active layer of the second light-emitting structure and contacts the p-type semiconductor layer of the second light-emitting structure, and
   wherein the third p-electrode passes through the first light-emitting structure and the second light-emitting structure and the n-type semiconductor layer and the active layer of the second light-emitting structure and contacts the p-type semiconductor layer of the third light-emitting structure.
Clause 14. The light-emitting device of clause 9, wherein one of the first light-emitting structure and the second light-emitting structure is configured to generate blue light and the other one of the first light-emitting structure and the second light-emitting structure is configured to generate green light, and the third light-emitting structure is configured to generate red light.
Clause 15. The light-emitting device of clause 1, further comprising a lens on the epitaxial structure.
Clause 16. The light-emitting device of clause 1, wherein the n-common electrode comprises a reflective electrode material.
Clause 17. The light-emitting device of clause 1, further comprising an insulating layer between the first light-emitting structure and the second light-emitting structure and between the second light-emitting structure and the third light-emitting structure.
Clause 18. A light-emitting device comprising:
   an epitaxial structure comprising a first light-emitting structure, a second light-emitting structure, and third light-emitting structure sequentially stacked in a vertical direction and configured to emit light of different wavelengths, wherein each of the first light-emitting structure, the second light-emitting structure, and the third light-emitting structure comprises a p-type semiconductor layer, an active layer, and an n-type semiconductor layer which are sequentially stacked, and a side surface of the n-type semiconductor layer of each of the first light-emitting structure, the second light-emitting structure, and the third light-emitting structure comprises a concave portion having a stepped shape that is concave with respect to side surfaces of the active layer and the p-type semiconductor layer of each of the first light-emitting structure, the second light-emitting structure, and the third light-emitting structure;
   a first p-electrode contacting the p-type semiconductor layer of the first light-emitting structure;
   a second p-electrode contacting the p-type semiconductor layer of the second light-emitting structure;
   a third p-electrode contacting the p-type semiconductor layer of the third light-emitting structure, at least one of the first p-electrode, the second p-electrode, and the third p-electrode having a conductive via structure;
   a separation layer on a side portion of the epitaxial structure and exposing the concave portion provided in the side surface of the n-type semiconductor layer of each of the first light-emitting structure, the second light-emitting structure, and the third light-emitting structure; and
   an n-common electrode comprising an n-common portion on the epitaxial structure, and an n-electrode portion extending along an outer surface of the separation layer from the n-common portion and contacting the side surface of the n-type semiconductor layer of each of the first light-emitting structure, the second light-emitting structure, and the third light-emitting structure through the concave portions.
Clause 19. The light-emitting device of clause 18, wherein the n-common electrode comprises a reflective electrode material.
Clause 20. A display apparatus comprising:
   a display panel comprising a light-emitting device;
   a driving circuit configured to switch the light-emitting device on/off; and
   at least one processor configured to input an on-off switching signal from the light-emitting device to the driving circuit based on an image signal,
   wherein the light-emitting device comprises:
      an epitaxial structure comprising a first light-emitting structure, a second light-emitting structure, and third light-emitting structure which are sequentially stacked in a vertical direction and configured to emit light of different wavelengths, a width of the first light-emitting structure being less than a width of the second light-emitting structure, the width of the second light-emitting structure being less than a width of third light-emitting structure in a horizontal direction orthogonal to the vertical direction, each of the first light-emitting structure, the second light-emitting structure, and the third light-emitting structure comprising a p-type semiconductor layer, an active layer, and an n-type semiconductor layer which are sequentially stacked;
      a first p-electrode contacting the p-type semiconductor layer of the first light-emitting structure;
      a second p-electrode contacting the p-type semiconductor layer of the second light-emitting structure;
      a third p-electrode contacting the p-type semiconductor layer of the third light-emitting structure, at least one of the first p-electrode, the second p-electrode, and the third p-electrode having a conductive via structure;
      an n-common electrode comprising an n-common portion under the epitaxial structure, and n-electrode portions extending from the n-common portion and contacting the side surface of the n-type semiconductor layer of each of the first light-emitting structure, the second light-emitting structure, and the third light-emitting structure, at least two of the n-electrode portions being on a side portion of the epitaxial structure and spaced apart from each other in the horizontal direction; and
      a separation layer between the n-common electrode and side surfaces of the p-type semiconductor layer and the active layer of each of the first light-emitting structure, the second light-emitting structure, and the third light-emitting structure.

It should be understood that embodiments described herein should be considered in a descriptive sense only and not for purposes of limitation. Descriptions of features or aspects within each embodiment should typically be considered as available for other similar features or aspects in other embodiments. While embodiments have been described with reference to the figures, it will be understood by one of ordinary skill in the art that various changes in form and details may be made therein without departing from the scope as defined by the following claims and their equivalents.

## Claims

1. A light-emitting device comprising:
an epitaxial structure comprising a first light-emitting structure, a second light-emitting structure, and a third light-emitting structure which are sequentially stacked in a vertical direction and configured to emit light of different wavelengths, a width of the first light-emitting structure being less than a width of the second light-emitting structure in a horizontal direction orthogonal to the vertical direction, the width of the second light-emitting structure being less than a width of third light-emitting structure in the horizontal direction, each of the first light-emitting structure, the second light-emitting structure, and the third light-emitting structure comprising a p-type semiconductor layer, an active layer, and an n-type semiconductor layer which are sequentially stacked;
a first p-electrode contacting the p-type semiconductor layer of the first light-emitting structure;
a second p-electrode contacting the p-type semiconductor layer of the second light-emitting structure;
a third p-electrode contacting the p-type semiconductor layer of the third light-emitting structure, at least one of the first p-electrode, the second p-electrode, and the third p-electrode having a conductive via structure;
an n-common electrode comprising an n-common portion under the epitaxial structure, and n-electrode portions extending from the n-common portion and contacting a side surface of the n-type semiconductor layer of each of the first light-emitting structure, the second light-emitting structure, and the third light-emitting structure, at least two of the n-electrode portions being on a side portion of the epitaxial structure and spaced apart from each other in the horizontal direction; and
a separation structure layer between on one hand the n-common electrode and on the other, side surfaces of the p-type semiconductor layer and the active layer of each of the first light-emitting structure, the second light-emitting structure, and the third light-emitting structure.

2. The light-emitting device of claim 1, wherein, in each of the first light-emitting structure, the second light-emitting structure, and the third light-emitting structure, the p-type semiconductor layer, the active layer, and the n-type semiconductor layer are sequentially stacked in the direction from the first light-emitting structure to the third light-emitting structure.

3. The light-emitting device of claim 2, wherein a width of the active layer and a width of the p-type semiconductor layer of each of the first light-emitting structure, the second light-emitting structure, and the third light-emitting structure are less than a width of the n-type semiconductor layer in the horizontal direction, and
wherein the n-electrode portions comprise a first n-electrode portion, a second n-electrode portion, and a third n-electrode portion on the side portion of the epitaxial structure and spaced apart from each other in the horizontal direction, the first n-electrode portion contacts the side surface of the n-type semiconductor layer of the first light-emitting structure, the second n-electrode portion contacts the side surface of the n-type semiconductor layer of the second light-emitting structure, and the third n-electrode portion contacts the side surface of the n-type semiconductor layer of the third light-emitting structure.

4. The light-emitting device of claim 3, wherein the separation structure layer comprises:
a first separation layer between the first n-electrode portion and the side surfaces of the p-type semiconductor layer and the active layer of the first light-emitting structure;
a second separation layer between the second n-electrode portion and the side surfaces of the p-type semiconductor layer and the active layer of the second light-emitting structure; and
a third separation layer between the third n-electrode portion and the side surfaces of the p-type semiconductor layer and the active layer of the third light-emitting structure.

5. The light-emitting device of claim 3 or 4, further comprising:
a first protective layer between the first n-electrode portion and the second n-electrode portion; and/or
a second protective layer between the second n-electrode portion and the third n-electrode portion.

6. The light-emitting device of any of the previous claims, wherein the first p-electrode contacts the p-type semiconductor layer of the first light-emitting structure,
wherein the second p-electrode passes through the first light-emitting structure and contacts the p-type semiconductor layer of the second light-emitting structure, and
wherein the third p-electrode passes through the first light-emitting structure and the second light-emitting structure and contacts the p-type semiconductor layer of the third light-emitting structure; and/or
wherein the first light-emitting structure is configured to emit red light, and one of the second light-emitting structure and the third light-emitting structure is configured to emit blue light and the other one of the second light-emitting structure and the third light-emitting structure is configured to emit green light.

7. The light-emitting device of claim 1, wherein, in each of the first light-emitting structure, the second light-emitting structure, and the third light-emitting structure, the n-type semiconductor layer, the active layer, and the p-type semiconductor layer are sequentially stacked in the direction from the first light-emitting structure to the third light-emitting structure.

8. The light-emitting device of claim 7, wherein, in each of the second light-emitting structure and the third light-emitting structure, a width of the n-type semiconductor layer is less than a width of the active layer and a width of the p-type semiconductor layer in the horizontal direction,
wherein the n-common electrode contacts a bottom surface of the n-type semiconductor layer of the first light-emitting structure, and
wherein the n-electrode portions comprise a second n-electrode portion and a third n-electrode portion on the side portion of the epitaxial structure spaced apart from each other in the horizontal direction, the second n-electrode portion contacts the side surface of the n-type semiconductor layer of the second light-emitting structure, and the third n-electrode portion contacts the side surface of the n-type semiconductor layer of the third light-emitting structure.

9. The light-emitting device of claim 8, wherein the separation structure layer comprises:
a first separation layer between the second n-electrode portion and the side surfaces of the n-type semiconductor layer, the active layer, and the p-type semiconductor layer of the first light-emitting structure; and/or
a second separation layer between the third n-electrode portion and the side surfaces of the p-type semiconductor layer and the active layer of the second light-emitting structure;
wherein preferably the first separation layer partially extends from the p-type semiconductor layer of the first light-emitting structure to the n-type semiconductor layer of the second light-emitting structure, and/or
wherein preferably the second separation layer partially extends from the p-type semiconductor layer of the second light-emitting structure to the n-type semiconductor layer of the third light-emitting structure.

10. The light-emitting device of claim 8 or 9, further comprising a protective layer between the second n-electrode portion and the third n-electrode portion.

11. The light-emitting device of any of claims 8 to 10, wherein the first p-electrode passes through the n-type semiconductor layer and the active layer of the first light-emitting structure and contacts the p-type semiconductor layer of the first light-emitting structure,
wherein the second p-electrode passes through the first light-emitting structure and the n-type semiconductor layer and the active layer of the second light-emitting structure and contacts the p-type semiconductor layer of the second light-emitting structure, and
wherein the third p-electrode passes through the first light-emitting structure and the second light-emitting structure and the n-type semiconductor layer and the active layer of the second light-emitting structure and contacts the p-type semiconductor layer of the third light-emitting structure.

12. The light-emitting device of any of claims 8 to 11, wherein one of the first light-emitting structure and the second light-emitting structure is configured to generate blue light and the other one of the first light-emitting structure and the second light-emitting structure is configured to generate green light, and the third light-emitting structure is configured to generate red light.

13. The light-emitting device of any of the previous claims, further comprising a lens on the epitaxial structure; and/or
wherein the n-common electrode comprises a reflective electrode material.

14. The light-emitting device of any of the previous claims, further comprising an insulating layer between the first light-emitting structure and the second light-emitting structure and/or between the second light-emitting structure and the third light-emitting structure.

15. A display apparatus comprising:
a display panel comprising a light-emitting device according to any of the previous claims;
a driving circuit configured to switch the light-emitting device on/off; and
at least one processor configured to input an on-off switching signal from the light-emitting device to the driving circuit based on an image signal.
